(19) Europäisches Patentamt
European Patent Office
Office européen des brevets

(11) **EP 4 489 076 A1**

(12) **EUROPEAN PATENT APPLICATION**

(43) Date of publication:
08.01.2025 Bulletin 2025/02

(21) Application number: 24185934.7

(22) Date of filing: 02.07.2024

(51) International Patent Classification (IPC):
*H01L 27/146* (2006.01)

(52) Cooperative Patent Classification (CPC):
H01L 27/14627; H01L 27/14605; H01L 27/14621;
H01L 27/14645

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 04.07.2023 KR 20230086565

(71) Applicant: Samsung Electronics Co., Ltd.
Suwon-si, Gyeonggi-do 16677 (KR)

(72) Inventors:
• **MUN, Sangeun**
**16678 Suwon-si (KR)**
• **ROH, Sookyoung**
**16678 Suwon-si (KR)**
• **AHN, Sungmo**
**16678 Suwon-si (KR)**

(74) Representative: **Elkington and Fife LLP**
**Prospect House**
**8 Pembroke Road**
**Sevenoaks, Kent TN13 1XR (GB)**

(54) **IMAGE SENSOR AND ELECTRONIC APPARATUS INCLUDING THE SAME**

(57) An image sensor may include pixel groups arranged in a Bayer pattern and a color separating lens array that separates incident light by wavelengths and concentrates the separated incident light on the pixels. The color separating lens array may include pixel corresponding groups, with each group having regions containing nanoposts in two layers. In each of the pixel corresponding groups in each of the two layers, there are a central group and a plurality of peripheral groups. The displacements of arrangement centers of the nanoposts in at least two of the peripheral groups have variations.

FIG. 3A

**Description**

FIELD OF THE INVENTION

The disclosure relates to an image sensor and an electronic apparatus including the same.

BACKGROUND OF THE INVENTION

Image sensors generally sense the color of incident light by using a color filter. However, a color filter may have low light utilization efficiency because the color filter absorbs light of colors other than the intended color of light. For example, when a red-green-blue (RGB) color filter is used, only 1/3 of the incident light is transmitted therethrough and the other part of the incident light, that is, 2/3 of the incident light, is absorbed. Thus, the light utilization efficiency is only about 33%. Most light loss in the image sensor occurs in the color filter. Accordingly, a method of separating colors by using each pixel in an image sensor without using a color filter has been attempted.

SUMMARY OF THE INVENTION

One or more example embodiments provide an image sensor including a color separation lens array capable of separating incident light according to wavelengths and condensing separated light.

Further, one or more example embodiments provide an image sensor including a color separation lens array having less performance variation with a chief ray angle.

Additional aspects will be set forth in part in the description which follows and, in part, will be apparent from the description, or may be learned by practice of the presented embodiments of the disclosure.

According to an aspect of the disclosure, An image sensor may include a sensor substrate including a plurality of unit pixel groups, each of the plurality of unit pixel groups including a first pixel, a second pixel, a third pixel, and a fourth pixel that are arranged in a Bayer pattern in two horizontal directions perpendicular to each other; and a color separating lens array spaced apart from the sensor substrate in a vertical direction that is perpendicular to the two horizontal direction, and configured to separate incident light according to wavelengths, and condense the incident light on each of the first to fourth pixels, wherein the color separating lens array includes a plurality of pixel corresponding groups respectively corresponding to the plurality of unit pixel groups, each of the plurality of pixel corresponding groups includes first to fourth pixel corresponding regions corresponding to the first to fourth pixels, each of the first to fourth pixel corresponding regions includes a plurality of first nanoposts arranged in a first layer and a plurality of second nanoposts arranged in a second layer, and the second layer is stacked on the first layer in the vertical direction, the plurality of pixel corresponding groups include a central group located at a center of the color separating lens array and a plurality of peripheral groups located away from the center, and displacements of an arrangement center of the first nanoposts and an arrangement center of the second nanoposts included in each of the first to fourth pixel corresponding regions in a direction perpendicular to the vertical direction are first to fourth displacements, and at least two of the first to fourth displacements are different from each other in each of the plurality of peripheral groups.

The first to fourth pixels included in each of the plurality of unit pixel groups may each include four photosensitive cells arranged in a 2x2 array.

An order of magnitudes of channel differences generated in four photosensitive cells included in each of the first to fourth pixels facing the first to fourth pixel corresponding regions of the plurality of peripheral groups may be the same in two or more of the first to fourth pixels.

Relative positional relationship of the plurality of second nanoposts in each of the first to fourth pixel corresponding regions in the peripheral group may be different from the relative positional relationship of the plurality of second nanoposts in each of the first to fourth pixel corresponding regions of the central group.

The first and fourth pixels may be green pixels, the second pixel may be a blue pixel, and the third pixel may be a red pixel.

In each of the plurality of peripheral groups, the first to fourth displacements may be each expressed as a vector sum of a common major displacement and first to fourth minor displacements, with respect to each of the plurality of peripheral groups, when CRA and $\varphi$ denote a chief ray angle CRA and an azimuth $\varphi$ determined according to the relative position on the image sensor, respectively, a and b denote unit vectors in the two horizontal directions, respectively, and CRA_max denotes a maximum value of the CRA, the common major displacement may be expressed as $C_M*(CRA/CRA\_max)*(-a*cos\varphi-b*sin\varphi)$, wherein $C_M$ may be a real number greater than 0.

At least two of the first to fourth minor displacements may be different from each other.

The first minor displacement and the fourth minor displacement may be the same as each other, and a magnitude of the second minor displacement and a magnitude of the third minor displacement may be greater than a magnitude of the first minor displacement.

The first minor displacement and the fourth minor displacement may be 0.

The second minor displacement may be expressed as $C_2*(CRA/CRA\_max)*(-a*\cos\varphi-b*\sin\varphi)$, the third minor displacement may be expressed as $C_3*(CRA/CRA\_max)*(-a*\cos\varphi-b*\sin\varphi)$, and $C_2$ and $C_3$ are real numbers greater than 0.

$C_2$ and $C_3$ may be different from each other.

The third minor displacement may be 0, the first minor displacement may be expressed as $D_1*(CRA/CRA\_max)*b*\sin\varphi$, the fourth minor displacement may be expressed as $D_4*(CRA/CRA\_max)*a*\cos\varphi$, the second minor displacement may be expressed as $D_{3b}*(CRA/CRA\_max)*b*\sin\varphi +D_{3a}*(CRA/CRA\_max)*a*\cos\varphi$, and $D_1$, $D_4$, $D_{3b}$, and $D_{3a}$ may be real numbers greater than 0.

At least two of $D_1$, $D_4$, $D_{3b}$, and $D_{3a}$ may be different from each other.

Relative positions of the plurality of second nanoposts in the second pixel corresponding region included in the peripheral group with respect to the second nanoposts in adjacent first pixel corresponding region and the second nanoposts in adjacent fourth pixel corresponding region may be, when compared with relative positions of the plurality of second nanoposts in the second pixel corresponding region included in the central group with respect to the second nanoposts in adjacent first pixel corresponding region and the second nanoposts in adjacent fourth pixel corresponding region, different as much as the second minor displacement.

Relative positions of the plurality of second nanoposts in the third pixel corresponding region included in the peripheral group with respect to the second nanoposts in adjacent first pixel corresponding region and the second nanoposts in adjacent fourth pixel corresponding region may be, when compared with relative positions of the plurality of second nanoposts in the third pixel corresponding region included in the central group with respect to the second nanoposts in adjacent first pixel corresponding region and the second nanoposts in adjacent fourth pixel corresponding region, different as much as the third minor displacement.

In each of the plurality of peripheral groups, an arrangement center of first nanoposts included in each of the first to fourth pixel corresponding regions may be out of line with centers of the first to fourth pixels facing the first to fourth pixel corresponding regions by a certain interval in a direction perpendicular to the vertical direction, and the certain interval may be in proportional to the CRA defined in each of the plurality of peripheral groups.

Relative positional relationship of the plurality of first nanoposts in each of the first to fourth pixel corresponding regions in the peripheral group may be different from the relative positional relationship of the plurality of first nanoposts in each of the first to fourth pixel corresponding regions of the central group.

The image sensor may further include an anti-reflection layer on the color separating lens array.

The anti-reflection layer may include a plurality of nanostructures.

The image sensor may further include a color filter array arranged between the sensor substrate and the color separating lens array.

According to another aspect of the disclosure, an electronic apparatus includes a lens assembly including one or more lenses and configured to form an optical image of an object, an image sensor configured to convert, into an electrical signal, the optical image formed by the lens assembly, and a processor configured to process a signal generated by the image sensor. The image sensor may include: a sensor substrate including unit pixel groups; and a color separating lens array including pixel corresponding groups respectively corresponding to the unit pixel groups, and configured to separate incident light according to wavelengths and condense the incident light on the unit pixel groups, the pixel corresponding groups of the color separating lens array include first nanoposts arranged in a first layer and second nanoposts arranged in a second layer, and the second layer is stacked on the first layer in a direction in which the sensor substrate is spaced apart from the color separating lens array. The plurality of pixel corresponding groups may include a central group located at a center of the color separating lens array and a plurality of peripheral groups located away from the center. In at least two of the pixel corresponding regions, displacements of an arrangement center of the first nanoposts in peripheral groups of the first layer is different from an arrangement center of the second nanoposts in peripheral groups of the second layer.

BRIEF DESCRIPTION OF THE DRAWINGS

The above and other aspects, features, and advantages of certain embodiments of the disclosure will be more apparent from the following description taken in conjunction with the accompanying drawings, in which:

FIG. 1 is a block diagram of an image sensor according to an embodiment;
FIG. 2A is a plan view showing a color arrangement of a pixel array in an image sensor according to an embodiment;
FIG. 2B and FIG. 2C are plan views showing a sensor substrate and a color separating lens array included in the pixel array of the image sensor according to the embodiment;
FIGS. 3A and 3B are different cross-sectional views of a pixel array in an image sensor according to an embodiment;
FIGS. 4A and 4B are plan views showing example structures of a first layer and a second layer in a color separating lens array included in a pixel array of an image sensor according to an embodiment;

FIG. 5 is a conceptual diagram illustrating a chief ray angle (CRA) incident on a pixel array of an image sensor according to an embodiment;

FIG. 6 is a plan view in which a plurality of pixel corresponding groups configuring the color separating lens array included in the pixel array of an image sensor according to an embodiment are defined as a central group and a peripheral group according to locations thereof, for describing a CRA and an azimuth;

FIGS. 7A and 7B are different cross-sectional views of a pixel array in an image sensor according to an embodiment, and are conceptual diagrams for describing arrangement of nanoposts in a pixel corresponding group included in a peripheral group;

FIG. 8 is a plan view for describing minor displacements of nanoposts in a second layer in pixel corresponding groups included in the peripheral group at various azimuth positions, in a color separating lens array included in a pixel array of an image sensor according to an embodiment;

FIGS. 9 and 10 are plan views for describing relative positional relationship between second nanoposts in a second layer in a pixel corresponding group that is a peripheral group, as compared with relative positional relationship between nanoposts in a second layer in a pixel corresponding group that is a center group, in the color separating lens array included in the pixel array included in the image sensor according to the embodiment;

FIGS. 11 and 12 are graphs showing an example of a channel difference appearing in image sensors according to a comparative example and according to an embodiment;

FIG. 13 is a plan view showing channel arrangement shown in the graphs of FIGS. 11 and 12;

FIGS. 14 and 15 are distributions showing a channel difference in a channel region, the channel difference appearing in image sensors according to a comparative example and an embodiment;

FIG. 16 is a plan view for describing examples of minor displacements of second nanoposts in a second layer of pixel corresponding groups included in the peripheral group at various azimuth positions, in a color separating lens array included in a pixel array of an image sensor according to another embodiment;

FIGS. 17 to 19 are plan views for describing relative positional relationship of second nanoposts in a second layer of a pixel corresponding group that is a peripheral group, as compared with relative positional relationship between nanoposts in a second layer of a pixel corresponding group that is a central group, in the color separating lens array included in the pixel array of FIG. 16;

FIGS. 20 to 23 are cross-sectional views schematically showing an image sensor pixel array according to some embodiments;

FIG. 24 is a block diagram of an electronic apparatus including an image sensor according to some embodiments; and

FIG. 25 is a block diagram of a camera module included in the electronic apparatus of FIG. 24.

## DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

The disclosure will be described in detail below with reference to accompanying drawings. The embodiments of the disclosure are capable of various modifications and may be embodied in many different forms. In the drawings, like reference numerals denote like components, and sizes of components in the drawings may be exaggerated for convenience of explanation.

Hereinafter, it will be understood that when a layer, region, or component is referred to as being "above" or "on" another layer, region, or component, it may be in contact with and directly on the other layer, region, or component, and intervening layers, regions, or components may be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

Also, the terms "... unit", "... module" used herein specify a unit for processing at least one function or operation, and this may be implemented with hardware or software or a combination of hardware and software.

The use of the term of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe technical detail, and the scope of rights is not limited by these terms unless the context is limited by the claims.

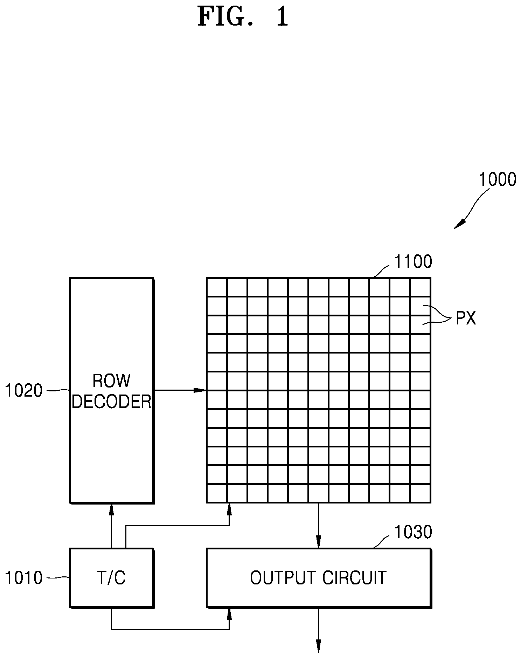

Referring to FIG. 1, an image sensor 1000 may include a pixel array 1100, a timing controller 1010, a row decoder 1020, and an output circuit 1030. The image sensor 1000 may include a charge-coupled device (CCD) image sensor or a complementary metal oxide semiconductor (CMOS) image sensor.

The pixel array 1100 includes pixels that are two-dimensionally disposed in a plurality of rows and columns. The row decoder 1020 selects one of the rows in the pixel array 1100 in response to a row address signal output from the timing controller 1010. The output circuit 1030 outputs a photosensitive signal in a line unit, from a plurality of pixels disposed in the selected row. To this end, the output circuit 1030 may include a column decoder and an analog-to-digital converter (ADC). For example, the output circuit 1030 may include a plurality of ADCs that are disposed respectively to columns between the column decoder and the pixel array 1100, or one ADC disposed at an output end of the column decoder. The timing controller 1010, the row decoder 1020, and the output circuit 1030 may be implemented as one chip or in separate chips. A processor for processing an image signal output from the output circuit 1030 may be implemented as one chip with the timing controller 1010, the row decoder 1020, and the output circuit 1030.

The pixel array 1100 may include a plurality of pixels PX that sense light of different wavelengths. The pixel arrangement may be implemented in various ways.

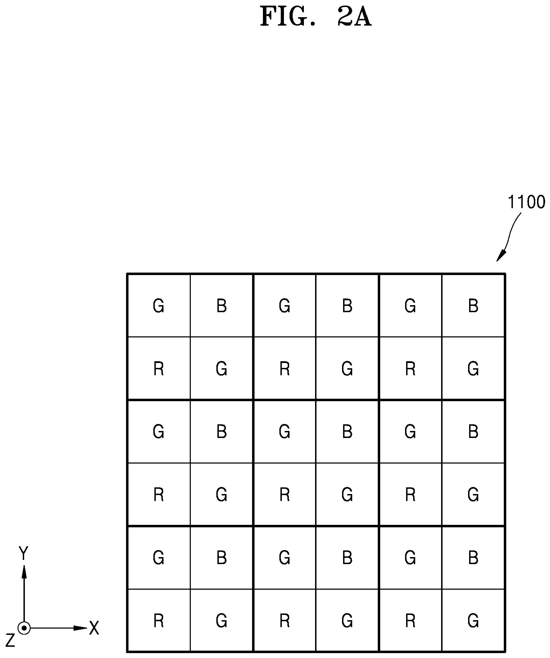

FIG. 2A is a plan view showing a color arrangement of the pixel array 1100 in the image sensor 1000 according to the embodiment.

The color arrangement shown in FIG. 2A is a Bayer pattern arrangement adopted in an image sensor. As shown in FIG. 2A, one unit pattern may include four quadrant regions, consisting of first to fourth quadrant regions, which respectively indicate blue (B), green (G), red (R), and green (G). The unit patterns may be repeatedly and two-dimensionally arranged in a first direction (X direction) and a second direction (Y direction). For the above color arrangement, two green pixels are arranged in one diagonal direction and one blue pixel and one red pixel are arranged in another diagonal direction in a unit pattern of a $2 \times 2$ array. In other words, a first row in which a plurality of green pixels and a plurality of blue pixels are alternately arranged in the first direction and a second row in which a plurality of red pixels and a plurality of green pixels are alternately arranged in the first direction may be repeatedly arranged in the second direction.

The color arrangement of FIG. 2A is an example, and one or more embodiments are not limited thereto. For example, a CYGM method, in which magenta (M), cyan (C), yellow (Y), and green (G) are represented in one unit pattern, or an RGBW method in which green, red, blue, and white are represented in one unit pattern may be used. Also, the unit patterns may be implemented in a 3x3 array, and the pixels in the pixel array 1100 may be arranged in various ways according to color characteristics of the image sensor 1000. Hereinafter, it will be described that the pixel array 1100 of the image sensor 1000 has the Bayer pattern, but the operating principles may be applied to other patterns of pixel arrangements than the Bayer pattern.

The pixel array 1100 of the image sensor 1000 may include a color separating lens array which are aligned with the color arrangement in a vertical direction (e.g., a z-axis direction), that is, the color separating lens array condensing light of a color corresponding to a certain pixel.

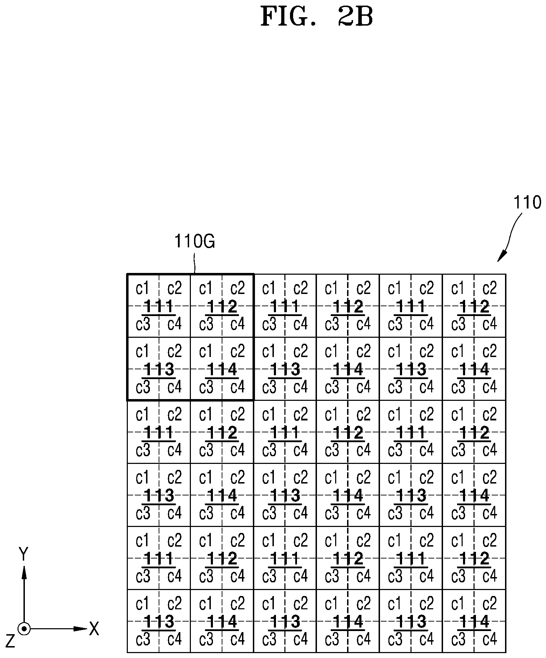

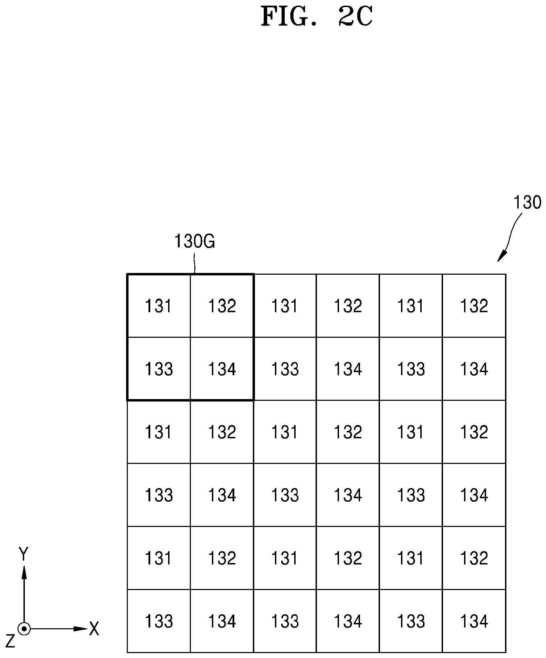

FIGS. 2B and 2C are plan views showing a sensor substrate 110 and the color separating lens array included in the pixel array of the image sensor according to the embodiment.

Referring to FIG. 2B, the sensor substrate 110 may include a plurality of pixels sensing incident light. The sensor substrate 110 may include a plurality of unit pixel groups 110G. The unit pixel group 110G may include a first pixel 111, a second pixel 112, a third pixel 113, and a fourth pixel 114 that generate image signals by converting incident light into electrical signals. The unit pixel group 110G may include a pixel arrangement in the Bayer pattern type. The pixel arrangement in the sensor substrate 110 is provided for sensing the incident light after distinguishing the incident light according to unit patterns such as the Bayer patterns. For example, the first and fourth pixels 111 and 114 may be green pixels sensing green light, the second pixel 112 may be a blue pixel sensing blue light, and the third pixel 113 may be a red pixel sensing red light. Hereinafter, the pixel arrangement of the image sensor may be used interchangeably with the pixel arrangement of the sensor substrate. Also, hereinafter, the first pixel 111 and the fourth pixel 114 may be interchangeably referred to as a first green pixel and a second green pixel, the second pixel 112 may be interchangeably referred to as a blue pixel, and the third pixel 113 may be interchangeably referred to as a red pixel. However, one or more embodiments are not limited thereto.

Each of the first to fourth pixels 111, 112, 113, and 114 may include a plurality of photosensitive cells that independently sense incident light. For example, each of the first to fourth pixels 111, 112, 113, and 114 may include first to fourth photosensitive cells C1, C2, C3, and C4. The first to fourth photosensitive cells C1, C2, C3, and C4 may be two-dimensionally arranged in the first direction (X-direction) and the second direction (Y-direction). For example, in each of the first to fourth pixels 111, 112, 113, and 114, the first to fourth photosensitive cells C1, C2, C3, and C4 may be disposed in a 2x2 array.

FIG. 2B shows an example in which each of the first to fourth pixels 111, 112, 113, and 114 includes four photosensitive cells, but four or more independent photosensitive cells may be grouped and two-dimensionally arranged. For example, each of the first to fourth pixels 111, 112, 113, and 114 may include a plurality of independent photosensitive cells that are grouped and disposed in a 3x3 array or 4x4 array. Hereinafter, an example in which each of the first to fourth pixels 111, 112, 113, and 114 includes the photosensitive cells disposed in a 2x2 array will be described for convenience of description.

According to the embodiment, some of the plurality of pixels each including the plurality of photosensitive cells sensing the light of the same color may be used as auto-focusing pixels. In the auto-focusing pixel, an auto-focusing signal may be obtained based on a difference between output signals of adjacent photosensitive cells. For example, an auto-focusing signal in the first direction (X-direction) may be generated based on a difference between output signals from the first photosensitive cell C1 and the second photosensitive cell C2, a difference between output signals from the third photosensitive cell C3 and the fourth photosensitive cell C4, or a difference between a sum of the output signals from the first photosensitive cell C1 and the third photosensitive cell C3 and a sum of the output signals from the second photosensitive cell C2 and the fourth photosensitive cell C4. Also, an auto-focusing signal in the second direction (Y-direction) may be generated based on a difference between output signals from the first photosensitive cell C1 and the third photosensitive cell C3, a difference between output signals from the second photosensitive cell C2 and the fourth photosensitive cell C4, or a difference between a sum of the output signals from the first photosensitive cell C1 and the second photosensitive cell C2 and a sum of the output signals from the third photosensitive cell C3 and the fourth photosensitive cell C4.

In addition, a general image signal may be obtained by summing output signals from the first to fourth photosensitive cells C1, C2, C3, and C4. For example, a first green image signal may be generated by summing the output signals from the first to fourth photosensitive cells C1, C2, C3, and C4 of the first pixel 111, a blue image signal may be generated by summing the output signals from the first to fourth photosensitive cells C1, C2, C3, and C4 of the second pixel 112, a red image signal may be generated by summing the output signals from the first to fourth photosensitive cells C1, C2, C3, and C4 of the third pixel 113, and a second green image signal may be generated by summing the output signals from the first to fourth photosensitive cells C1, C2, C3, and C4 of the fourth pixel 114.

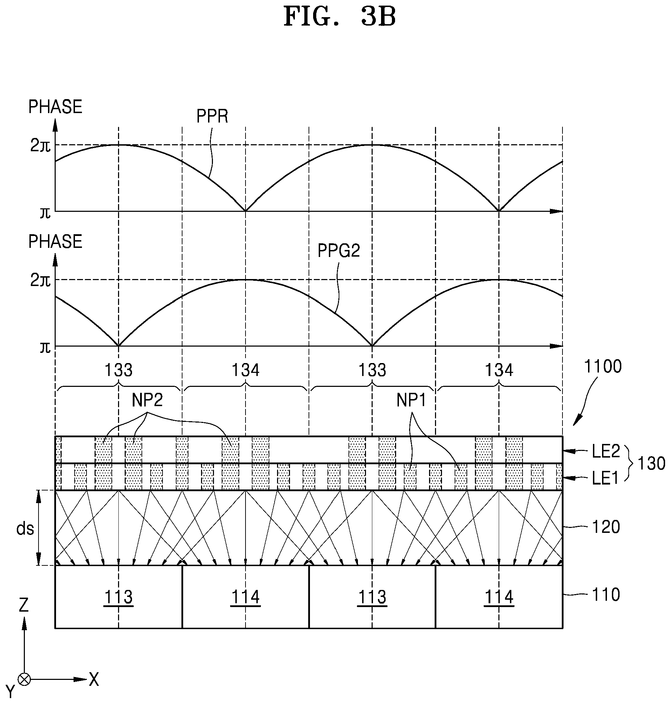

Referring to FIG. 2C, a color separating lens array 130 may include a plurality of pixel corresponding regions. The color separating lens array 130 includes a plurality of pixel corresponding groups 130G respectively corresponding to the plurality of unit pixel groups 110G of the sensor substrate 110 shown in FIG. 3B. The pixel corresponding group 130G includes first to fourth pixel corresponding regions 131, 132, 133, and 134 corresponding to the first to fourth pixels 111, 112, 113, and 114.

That is, the first to fourth pixel corresponding regions 131, 132, 133, and 134 of the color separating lens array 130 may be arranged to face the first to fourth pixels 111, 112, 113, and 114 of the sensor substrate 110, respectively. The first to fourth pixel corresponding regions 131, 132, 133, and 134 may be two-dimensionally arranged in the first direction (X direction) and the second direction (Y direction), such that a first row in which the first pixel corresponding region 131 and the second pixel corresponding region 132 are alternately arranged and a second row in which the third pixel corresponding region 133 and the fourth pixel corresponding region 134 are alternately arranged and repeated.

The first to fourth pixel corresponding regions 131, 132, 133, and 134 each include a plurality of nanoposts. The plurality of nanoposts are configured to separate incident light according to wavelengths and condense the light to the corresponding first to fourth pixels 111, 112, 113, and 114 according to the wavelengths. As described above with reference to FIG. 2B, the first pixel 111 and the fourth pixel 114 may be respectively a first green pixel and a second green pixel, the second pixel 112 may be a blue pixel, and the third pixel 113 may be a red pixel. In this case, the first pixel corresponding region 131 and the fourth pixel corresponding region 134 may be interchangeably referred to as a first green pixel corresponding region and a second green pixel corresponding region, the second pixel corresponding region 132 may be interchangeably referred to as a blue pixel corresponding region, and the third pixel corresponding region 133 may be interchangeably referred to as a red pixel corresponding region.

The shapes and arrangement of the plurality of nanoposts included in the color separating lens array 130 may be set to form a phase profile that is appropriate to the wavelength separation, and the detailed shape and arrangement of the nanoposts may be adjusted according to a relative position of the pixel corresponding group 130G in which the nanoposts are included in the color separating lens array 130.

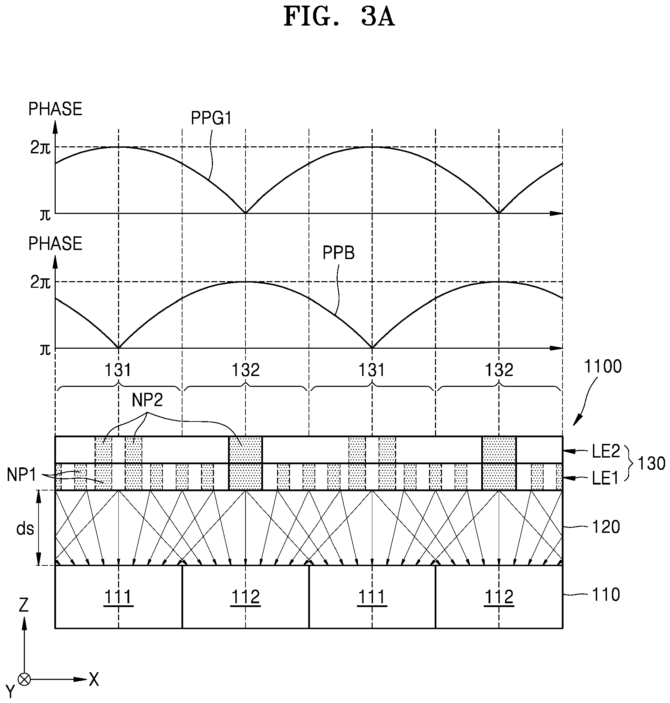

FIGS. 3A and 3B are cross-sectional views of the pixel array 1100, seen from different cross-sections, in the image sensor of FIG. 1.

FIG. 3A is a cross-sectional view showing a phase profile PPG1 of green light after passing through the color separating lens array 130 and a phase profile PPB of blue light after passing through the color separating lens array 130, and FIG. 3B is a cross-sectional view showing a phase profile PPR of red light and a phase profile PPG2 after passing through the color separating lens array 130.

Referring to FIGS. 3A and 3B, the pixel array 1100 of the image sensor 1000 includes the sensor substrate 110 and the color separating lens array 130 arranged on the sensor substrate 110.

The sensor substrate 110 may include the first pixel 111, the second pixel 112, the third pixel 113, and the fourth pixel 114 sensing light as described above with reference to FIG. 2B, and each of the first pixel 111, the second pixel 112, the third pixel 113, and the fourth pixel 114 may include a plurality of photosensitive cells. A separator (e.g., a wall) for separating cells may be further formed on a boundary between cells.

A transparent spacer layer 120 may be arranged between the sensor substrate 110 and the color separating lens array 130. A color filter array may be further arranged between the sensor substrate 110 and the spacer layer 120. The color filter array may include a red filter, a green filter, and a blue filter, and the filters may be arranged corresponding to the color arrangement as shown in FIG. 2A, for example. Because the color separating lens array 130 performs the color separation in the embodiment, adding of the color filter array may improve a color purity by supplementing some errors that may occur during the color separation of the color separating lens array 130.

The spacer layer 120 supports the color separating lens array 130 and may have a thickness ds that satisfies a regulation about a distance between the sensor substrate 110 and the color separating lens array 130, that is, a distance between an upper surface of the sensor substrate 110 and a lower surface of the color separating lens array 130. The thickness ds of the spacer layer 120 may vary depending on whether the color filter array is provided between the color separating lens array 130 and the sensor substrate 110.

The spacer layer 120 may include a material transparent with respect to the visible ray, for example, a dielectric material having a lower refractive index than that of the nanoposts NP and low absorption coefficient in the visible ray band, e.g., $SiO_2$, siloxane-based spin on glass (SOG), etc. When the peripheral material layer filled between the nanoposts NP has a higher refractive index than that of the nanoposts NP, the spacer layer 120 may include a material having a lower refractive index than that of the peripheral material layer.

The thickness ds of the spacer layer 120 may be selected within a range of $ht - p \leq ds \leq ht + p$. Here, ht denotes a focal length of light at the peak wavelength in a wavelength band branched by the color separating lens array 130, and p denotes a pixel pitch. In an embodiment, the pixel pitch may be a few $\mu$m or less, for example, 2 $\mu$m or less, 1.5 $\mu$m or less, 1 $\mu$m or less, or 0.7 $\mu$m or less. The pixel pitch may be within a range of about 0.5 $\mu$m to about 1.5 $\mu$m. The thickness of the spacer layer 120 may be determined based on, for example, the center wavelength of the green light, that is, 540 nm.

When the color filter array is arranged between the sensor substrate 110 and the color separating lens array 130, in consideration of the thickness of the color filter array, the thickness of the spacer layer 120 may be set to be less than the focal length of the color separating lens array 130 with respect to the light of the center wavelength from among the wavelength bands separated by the color separating lens array 130. For example, the thickness may be set to be less than a focal length of the green light by the color separating lens array 130.

An etch-stop layer may be further provided between the spacer layer 120 and the color separating lens array 130. The etch-stop layer may be provided to protect the spacer layer 120 that is the structure under the color separating lens array 130, during the process of manufacturing the color separating lens array 130. For example, a condition about the distance between the lower surface of the color separating lens array 130 and the upper surface of the sensor substrate 110 may be maintained due to the etch-stop layer.

Also, a protective layer for protecting the color separating lens array 130 may be further disposed on the color separating lens array 130. The protective layer may include a material functioning as an anti-reflection layer.

The first green pixel corresponding region 131 corresponds to the first green pixel 111 and may be positioned directly above the first green pixel 111. The blue pixel corresponding region 132 corresponds to the blue pixel 112 and may be positioned directly above the blue pixel 112. The red pixel corresponding region 133 corresponds to the red pixel 113 and may be positioned directly above the red pixel 113. The second green pixel corresponding region 134 corresponds to the second green pixel 114 and may be positioned directly above the second green pixel 114.

The color separating lens array 130 includes first nanoposts NP1 and second nanoposts NP2 arranged in a plurality of layers. The plurality of first nanoposts NP1 form a first layer LE1 of the color separating lens array 130, and the plurality of second nanoposts NP2 form a second layer LE2 of the color separating lens array 130. The first layer LE1 and the second layer LE2 are stacked in a third direction (Z-direction), and the first layer LE1 is close to the sensor substrate 110. An etch-stop layer may be further disposed between the first layer LE1 and the second layer LE2. The etch-stop layer may be provided, for example, in order to prevent damage to the first layer LE1, which may occur during manufacturing the second layer LE2 on the first layer LE1 after forming the first layer LE1. For example, the first nanoposts NP1 in the first layer LE1 may be formed to a desired height owing to the etch-stop layer.

The first pixel corresponding region 131 includes the plurality of first nanoposts NP1 arranged in the first layer LE1 and the plurality of second nanoposts NP2 arranged in the second layer LE2. The second pixel corresponding region 132, the third pixel corresponding region 133, and the fourth pixel corresponding region 134 also include a plurality of first nanoposts NP1 arranged in the first layer LE1 and a plurality of second nanoposts NP2 arranged in the second layer LE2. Common characteristics of the first and second nanoposts NP1 and NP2 are described in the name of nanoposts NP.

Sizes, shapes, intervals, and/or arrangement of the plurality of nanoposts NP included in the color separating lens array 130 may be determined such that the green light is separated and condensed on the first and second green pixels 111 and 114, the blue light is separated and condensed to the blue pixel 112, and the red light is separated and condensed to the red pixel 113.

The nanoposts NP may have a shape dimension of a sub wavelength. Here, the sub-wavelength refers to a wavelength that is less than a wavelength band of light to be branched. The nanoposts NP may have a dimension that is less than a peak wavelength of a wavelength band of the light to be branched, for example. The nanoposts NP may have a cylindrical shape having a cross-sectional diameter of a sub wavelength. However, the shape of the nanoposts NP is not limited thereto, that is, the nanoposts NP may have an elliptical post shape or a polygonal post shape. Otherwise, the nanoposts NP may have post shapes having symmetrical or asymmetrical cross-sectional shape. The nanoposts NP are shown so that a width in the direction perpendicular to a height direction (Z-direction) is constant, that is, a cross-section parallel to the height direction has a rectangular shape, but the above shape is an example. Unlike the example, the widths of the nanoposts NP in the direction perpendicular to the height direction may not be consistent, for example, the cross-section parallel to the height direction may have a trapezoidal shape or an inverted trapezoidal shape. When the incident light Li is a visible ray, the cross-sectional diameter of the nanoposts NP may be less than, for example, 400 nm, 300 nm, or 200 nm.

In addition, a height of the nanoposts NP may be about 500 nm to about 1500 nm, which is greater than the cross-sectional diameter of the nanopost. The height of the nanoposts NP may be a few times greater than the sub wavelength to a wavelength. For example, the height of the nanoposts NP may be five times, four times, or three times or less the peak wavelength of a wavelength band separated by the color separating lens array 130. The nanoposts NP included in the first to fourth pixel corresponding regions 131, 132, 133, and 134 and the nanoposts NP included in the first layer LE1 and the second layer LE2 are shown to have the same height, but are not limited thereto. In addition, arrangement type, widths, and the number of the nanoposts NP are examples. The widths, heights, the number, and arrangement type of the nanoposts NP may be determined to be suitable for forming the phase profile for color separation, or may be determined considering detailed processing conditions.

A peripheral material having a refractive index that is different from that of the nanoposts NP may be filled or inserted between the nanoposts NP so that the nanoposts NP are surrounded or encircled by the peripheral material. The nanoposts NP may include a material having a higher refractive index than that of a peripheral material. For example, the nanoposts NP may include c-Si, p-Si, a-Si and a Group III-V compound semiconductor (GaP, GaN, GaAs, etc.), SiC, $TiO_2$, SiN, and/or a combination thereof. The nanoposts NP having a different refractive index from the refractive index of the peripheral material may change the phase of light that passes through the nanoposts NP. This is caused by phase delay that occurs due to the shape dimension of the sub-wavelength of the nanoposts NP, and a degree at which the phase is delayed, may be determined by a detailed shape dimension and arrangement shape of the nanoposts NP. A peripheral material of the nanoposts NP may include a dielectric material having a lower refractive index than that of the nanoposts NP. For example, the peripheral material may include $SiO_2$ or air. However, one or more embodiments are not limited thereto, that is, the materials of the nanoposts NP and the peripheral material may be set so that the nanoposts NP may have a lower refractive index than that of the peripheral material.

The nanoposts NP1 and the second nanoposts NP2 are not limited to the same material, that is, may have the same material or different materials from each other. A peripheral material between the first nanoposts NP1 in the first layer LE1 and a peripheral material between the second nanoposts NP2 in the second layer LE2 may be the same as each other or different from each other.

Because a refractive index of a material varies depending on a wavelength of light, the color separating lens array 130 may provide different phase profiles with respect to the different wavelengths. In other words, because the same material has a different refractive index according to the wavelength of light reacting with the material and a phase delay of the light that passes through the material is different according to the wavelength, the phase profile may vary depending on the wavelength. For example, a refractive index of the first pixel corresponding region 131 with respect to the light of first wavelength and a refractive index of the first pixel corresponding region 131 with respect to the light of second wavelength may be different from each other, and a phase delay that the light of first wavelength passing through the first pixel corresponding region 131 goes through and a phase delay that the light of second wavelength passing through the first pixel corresponding region 131 goes through. When the color separating lens array 130 is designed in consideration of the characteristics of light, different phase profiles may be provided with respect to light of different wavelengths.

The color separating lens array 130 may include the nanoposts NP that are arranged based on a certain rule so that the incident light may have the first green light phase profile PPG1, the blue light phase profile PPB, the red light phase profile PPR, and the second green light phase profile PPG2 as shown in FIGS. 3A and 3B, at the position after passing through the color separating lens array 130. Here, the rule may be applied to parameters, such as the shape of the nanoposts NP, sizes (e.g., a width and a height), a distance between the nanoposts NP, the arrangement form thereof, and the number of stacks, etc., and these parameters may be determined according to a phase profile to be implemented by the color separating lens array 130.

The arrangement rules of the first and second nanoposts NP1 and NP2 included respectively in the first to fourth pixel corresponding regions 131, 132, 133, and 134 may be different from each other. For example, the arrangement rule of the first nanoposts NP1 in the first layer LE1 of the first pixel corresponding region 131 and the arrangement rule of the first nanoposts NP1 in the first layer LE1 of the second pixel corresponding region 132 may be different from each other. The arrangement rule of the second nanoposts NP2 in the second layer LE2 of the first pixel corresponding region 131 and the arrangement rule of the second nanoposts NP2 in the second layer LE2 of the second pixel corresponding region 132 may be different from each other. In other words, sizes, shapes, intervals, and/or arrangements of the first nanoposts NP1 and the second nanoposts NP2 included in the first pixel corresponding region 131 may be different from those of the first nanoposts NP1 and the second nanoposts NP2 included in the second pixel corresponding region 132, and may be also different from those of the first nanoposts NP1 and the second nanoposts NP2 included in the third pixel corresponding region 133.

The region classification of the color separating lens array 130 and shapes and arrangements of the first and second nanoposts NP1 and NP2 arranged in the first layer LE1 and the second layer LE2 in each region may be set so as to form the phase profiles in which the incident light is separated according to wavelengths and condensed to the first to fourth pixels 111, 112, 113, and 114. The separation according to wavelength may include a color separation in the visible ray band, but is not limited thereto, that is, the wavelength band may be expanded to the visible ray to infrared ray range, or other various ranges.

Referring to FIG. 3A, the green light that has passed through the color separating lens array 130 may have a first green light phase profile PPG1 that is the largest at the center of the first green pixel corresponding region 131 and is reduced away from the center of the first green pixel corresponding region 131. In detail, immediately after passing through the color separating lens array 130, that is, at a lower surface of the color separating lens array 130 or an upper surface of the spacer layer 120, the phase of the green light is the largest at the center of the first green pixel corresponding region 131 and reduced as a concentric circle away from the center of the first green pixel corresponding region 131. Thus, the phase is the smallest at the centers of the blue and red pixel corresponding regions 132 and 133 in the X and Y directions, and at contact points between the first green pixel corresponding region 131 and the second green pixel corresponding region 134 in the diagonal direction.

Also, the blue light that has passed through the color separating lens array 130 may have a blue light phase profile PPB that is largest at the center of the blue pixel corresponding region 132 and reduces away from the center of the blue pixel corresponding region 132. In detail, immediately after passing through the color separating lens array 130, the phase of the blue light is the largest at the center of the blue pixel corresponding region 132 and reduced as a concentric circle away from the center of the blue pixel corresponding region 132, the phase is the smallest at the centers of the first and second green pixel corresponding regions 131 and 134 in the X direction and the Y direction and the smallest at the center of the red pixel corresponding region 133 in the diagonal direction.

Referring to FIG. 3B, the red light that has passed through the color separating lens array 130 may have a red light phase profile PPR that is the largest at the center of the red pixel corresponding region 133 and is reduced away from the center of the red pixel corresponding region 133. Referring to FIG. 3B, the green light that has passed through the color separating lens array 130 may have a second green light phase profile PPG2 that is the largest at the center of the second green pixel corresponding region 134 and is reduced away from the center of the second green pixel corresponding region 134. When comparing the first green light phase profile PPG1 of FIG. 3A with the second green light phase profile PPG2 of FIG. 3B, the second green light phase profile PPG2 is obtained by moving in parallel with the first green light phase profile PPG1 by one-pixel pitch in the X direction and the Y direction, and descriptions about the first green light phase profile PPG1 may be applied to the others.

In addition, the regions of the color separating lens array 130 may be described to include a green light condensing region for condensing the green light, a blue light condensing region for condensing the blue light, and a red light condensing region for condensing the red light. The green light condensing region, the blue light condensing region, and the red light condensing region defined by the above phase profile may partially overlap one another. The green light condensing region may have a greater area than the green pixel corresponding region, the blue light condensing region may have a greater area than the blue pixel corresponding region, and the red light condensing region may have a greater area than the red pixel corresponding region.

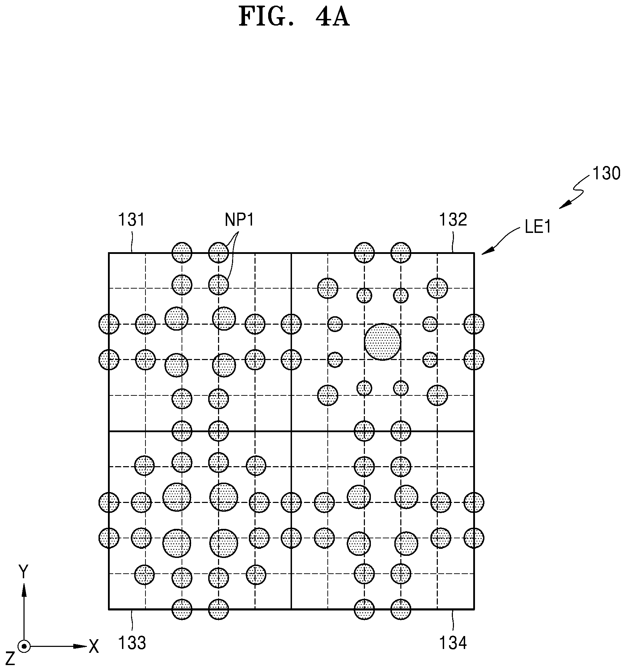

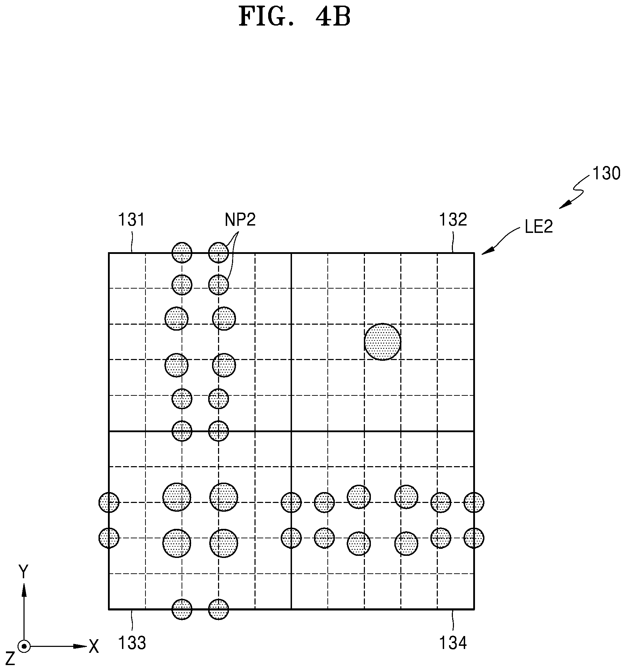

FIGS. 4A and 4B are plan views showing example structures of a first layer and a second layer in the color separating lens array 130 included in a pixel array of an image sensor according to an embodiment.

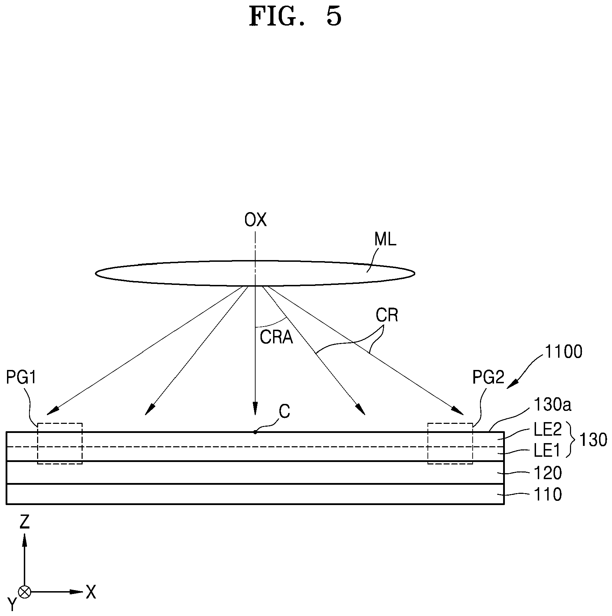

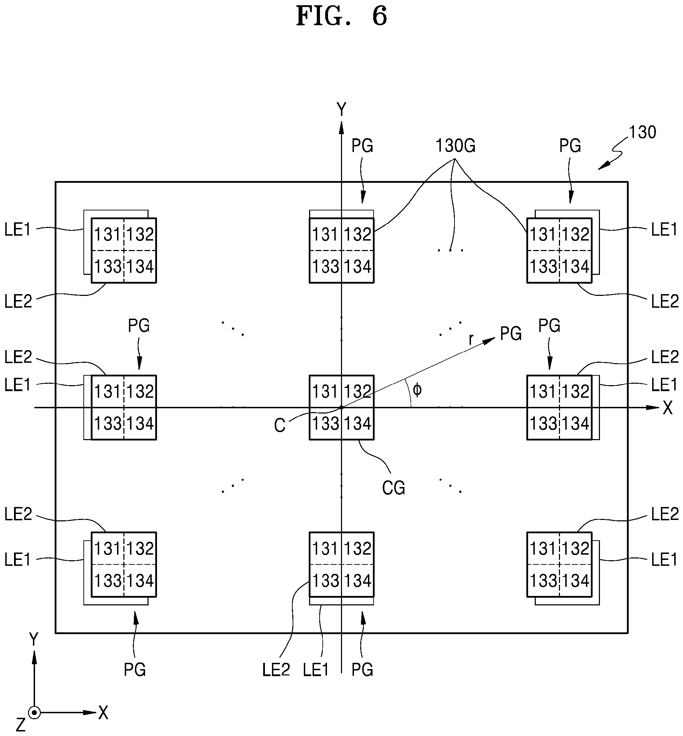

The arrangements of the first nanoposts NP1 and the second nanoposts NP2 in the color separating lens array 130 shown in the cross-sectional views of FIGS. 3A and 3B and the plan views of FIGS. 4A and 4B correspond to the pixel corresponding group of the center group. The plurality of pixel corresponding groups 130G forming the color separating lens array 130 described above with reference to FIG. 2C may be categorized into a center group and a peripheral group according to relative locations thereof with respect to the center of the color separating lens array 130 as seen from above, and this is described below with reference to FIGS. 5 and 6. In addition, the arrangements of the first nanoposts NP1 and the second nanoposts NP2 in the pixel corresponding group that is the peripheral group are described in detail later with reference to FIG. 6 and so on.

In the first to fourth pixel corresponding regions 131, 132, 133, and 134 of the central group, the first nanoposts NP1 in the first layer LE1 may be aligned with the second nanoposts NP2 in the second layer LE2 in a vertical direction (i.e.

a z-axis direction). Here, the alignment denotes that the center of the arrangement of the first nanoposts NP1 and the center of the arrangement of the second nanoposts NP2 in the first pixel corresponding region 131 are aligned so as to overlap each other when seen from the third direction (a Z-direction) in which the first layer LE1 and the second layer LE2 are stacked. In FIGS. 4A and 4B, the first nanoposts NP1 are provided at the lower portions of corresponding second nanoposts NP2, and the second nanoposts NP2 and the first nanoposts NP1 at the positions facing each other in the upper and lower layers have the same cross-sectional area and are arranged to be aligned with each other. However, the embodiments are not limited thereto. The cross-sectional areas of the second nanoposts NP2 and the first nanoposts NP1 at positions facing each other in the upper and lower layers may be different from each other. The second nanoposts NP2 and the first nanoposts NP1 at positions facing each other in the upper and lower layers may be arranged offset with each other.

In each of the first pixel corresponding region 131, the second pixel corresponding region 132, the third pixel corresponding region 133, and the fourth pixel corresponding region 134, the center of the arrangement of the second nanoposts NP2 and the center of the arrangement of the first nanoposts NP1 may be aligned with each other.

The pixel arrangement characteristics of Bayer pattern may be applied to the arrangement of the nanoposts NP in the pixel corresponding regions 131, 132, 133, and 134 shown in FIGS. 4A and 4B. In the Bayer pattern pixel arrangement, adjacent pixels to the blue pixel 112 and the red pixel 113 in the first direction (X direction) and the second direction (Y direction) are same as the green pixels G, whereas the adjacent pixel to the first green pixel 111 in the first direction (X direction) is the blue pixel 112 and the adjacent pixel to the first green pixel 111 in the second direction (a Y direction) is the red pixel R. In addition, the adjacent pixel to the second green pixel 114 in the first direction (an X direction) is the red pixel 113 and the adjacent pixel to the second green pixel 114 in the second direction (Y direction) is the blue pixel 114. In addition, adjacent pixels to the first and second green pixels 111 and 114 in four diagonal directions are green pixels, adjacent pixels to the blue pixel 112 in the four diagonal directions are the red pixels 113, and adjacent pixels to the red pixel 113 in the four diagonal directions are the blue pixels 112. Therefore, in the blue and red pixel corresponding regions 132 and 133 respectively corresponding to the blue pixel 112 and the red pixel 113, the nanoposts NP may be arranged in the form of 4-fold symmetry, and in the first and second green pixel corresponding regions 131 and 134, the nanoposts NP may be arranged in the form of 2-fold symmetry. The arrangement of nanoposts NP in the first and second green pixel corresponding regions 131 and 134 may be rotated by 90° angle with respect to each other.

Unlike FIGS. 4A and 4B showing that the nanoposts NP in the first and second green pixel corresponding regions 131 and 134 and the blue and red pixel corresponding regions 132 and 133 have symmetrical cross-sections having the identical widths in the first direction (X direction) and the second direction (Y direction), the nanoposts NP in the first and second green pixel corresponding regions 131 and 134 may have asymmetrical cross-sections having different widths in the first direction (X direction) and the second direction (Y direction). The arrangement rule of the nanoposts NP is an example for separating wavelengths corresponding to the pixel arrangement, and is not limited to the example description or pattern shown in the drawings.

The above arrangement rule may be applied to each of the first nanoposts NP1 in the first layer LE1 and the second nanoposts NP2 in the second layer LE2 in each of the first to fourth pixel corresponding regions 131, 132, 133, and 134.

FIG. 5 is a conceptual diagram illustrating a chief ray angle (CRA) incident on a pixel array of an image sensor according to an embodiment.

A pixel array 1100 of an image sensor may be adopted in a camera module along with a module lens ML, and the light going toward the pixel array 1100 through the module lens ML may have different incident angles according to incident positions on the pixel array 1100. An incident angle of the light incident on the pixel array 1100 is typically defined to be a CRA. A chief ray (CR) denotes a ray of light starting from one point of a subject and being incident to the pixel array 1100 after passing through the center of the module lens ML. The CRA denotes an angle between the CR and an optical axis OX, and in other words, an angle formed with a normal of an incident surface 130a of the color separating lens array 130.

The CRA of the light incident to a center C of the color separating lens array 130 is 0°, and the CRA of the incident light increases toward the edge of the color separating lens array 130. Also, the direction of CR varies depending on the azimuth of the edge. For example, in the color separating lens array 130, the CRs incident on a peripheral group PG1 located at a left periphery portion and a peripheral group PG2 located at a right periphery portion, of which distances from the center C are equal to each other, have the same CRA and incident directions opposite to each other with respect to the normal of the incident surface.

The pixel array 1100 of the image sensor according to the embodiment sets detailed shapes and arrangement of the nanoposts NP forming the color separating lens array 130, in consideration of the CRA and the direction.

The color separating lens array 130 efficiently operates with respect to the light incident on the color separating lens array within a certain angle range, but when the incidence angle is away from the certain angle range, the color separation performance of the color separating lens array 130 may degrade. Therefore, for example, when the first to fourth pixel corresponding regions 131, 132, 133, and 134 are designed to be equal to one another in the entire region of the image sensor 1000, a color separating efficiency may vary depending on the region of the image sensor 1000, and a signal difference may occur between a plurality of photosensitive cells corresponding to the same pixel, that is, quality of the image provided by the image sensor 1000 may degrade.

When the plurality of first to fourth pixels 111, 112, 113, and 114 each have a plurality of photosensitive cells, there may be a signal difference between the plurality of photosensitive cells corresponding to the identical pixel and is referred to as a channel difference. The channel difference may occur due to the structural variation that may be generated during manufacturing processes and may also occur due to the CRA. Also, the light of different wavelengths has different focal lengths, and the channel difference due to the CRA may also vary depending on the wavelengths. The channel difference may degrade image quality obtained from the image sensor 1000. The channel difference may cause an error when an automatic focusing signal is generated. As described above with reference to FIG. 2B, when each of the first to fourth pixels 111, 112, 113, and 114 includes the first to fourth photosensitive cells c1, c2, c3, and c4, for example, the automatic focusing signal may be obtained by using a difference between sum of the output signals from the first photosensitive cell c1 and the third photosensitive cell c3 and sum of the output signals from the second photosensitive cell c2 and the fourth photosensitive cell c4. When the difference has a value of 0, it may be determined that the image sensor 1000 is appropriately located on a focal plane of a module lens in the imaging device including the image sensor 1000. When the difference value is not 0, the module lens may be moved according to the difference value and the sign thereof so that the image sensor 1000 is located on the focal plane of the module lens. However, when there is the channel difference, the auto focusing signals may not be symmetrical with respect to 0°, and the accuracy of the auto focusing signal may degrade. Accordingly, the auto focusing signal needs to be generated considering the channel difference, and operations thereof may be complicated.

The image sensor 1000 according to the embodiment may be designed so that the arrangement type of the nanoposts NP of the color separating lens array 130 may vary considering the CRA of the incident light, which varies depending on the location on the image sensor 130. For example, the arrangements of the first nanoposts NP1 and the second nanoposts NP2 included in each of the first to fourth pixel corresponding regions 131, 132, 133, and 134 of the color separating lens array 130 may be adjusted differently according to the relative positional relationship based on the center of the color separating lens array 130.

FIG. 6 is a plan view in which a plurality of pixel corresponding groups configuring the color separating lens array included in the pixel array of an image sensor according to an embodiment are defined as a central group and a peripheral group according to locations thereof, for describing a CRA and an azimuth.

Referring to FIG. 6, pixel corresponding groups 130G in the color separating lens array 130 may be two-dimensionally arranged in the first direction (an X direction) and the second direction (a Y direction). The pixel corresponding groups 130G may be defined as a central group CG and peripheral groups PG according to positions thereof. The central group CG denotes a pixel corresponding group located at the center of the color separating lens array 130, and the peripheral groups PG denote pixel corresponding groups spaced apart from the center, that is, other pixel corresponding groups than the central group CG. In FIG. 6, the central group CG is shown as one central group CG located at the center C, but for convenience of design, the central group CG may be defined as a plurality of groups located at the center portion.

The location of the peripheral group PG may be expressed by a distance r and an azimuth φ from the center C of the color separating lens array 130. The azimuth φ may be defined based on an axis that is in parallel to the first direction (X-axis) while passing through the center C of the color separating lens array 130. The distance r defining the position of the peripheral group PG is related to the CRA. When r is 0, that is, at the center C of the color separating lens array 130, the CRA is 0°, and as the distance r increases, the CRA also increases.

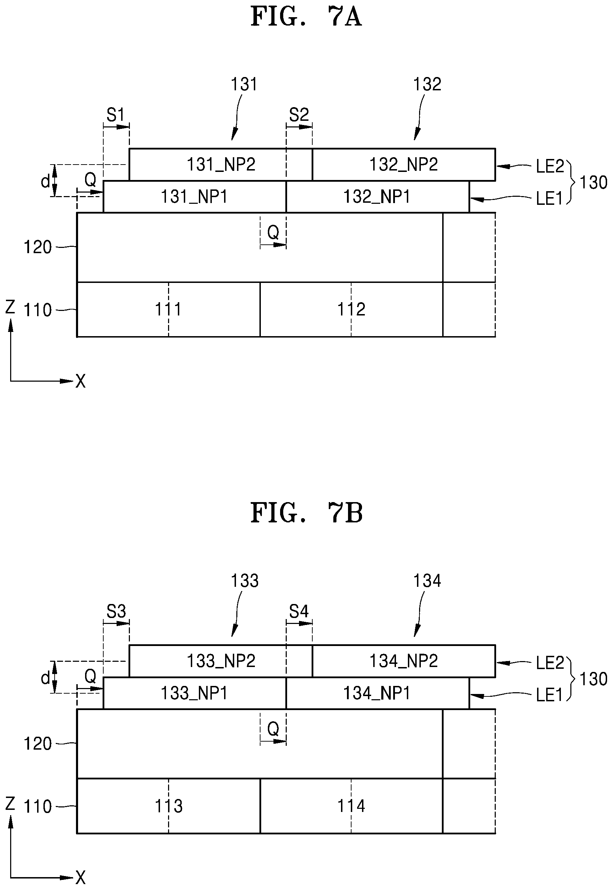

In the descriptions about the cross-sectional views of FIGS. 3A and 3B, in each of the first to fourth pixel corresponding regions 131, 132, 133, and 134 included in the central group CG, the second nanoposts NP2 in the second layer LE2 are described to be aligned with the first nanoposts NP1 of the first layer LE1. In the peripheral group PG, the second layer LE2 may not be aligned, and may be out of line, with the first layer LE1. In other words, the center of the arrangement of the second nanoposts NP2 in the second layer LE2 and the center of the arrangement of the first nanoposts NP1 in the first layer LE1 are arranged offset with each other. Hereinafter, this may be referred to as that the second layer LE2 and the first layer LE1 are arranged offset with each other. Here, the term "center of a nanopost arrangement" or "arrangement center" of nanoposts may refer to a central point of an area defined by connecting the nanoposts posited on the outermost boundaries. In the first to fourth pixel corresponding regions 131, 132, 133, and 134 of the peripheral group PG, a direction in which the second layer LE2 is offset with the first layer LE1 is toward the center C of the color separating lens array. The degree or direction of deviation shown in FIG. 6 is an example and is not limited thereto. In each of the first to fourth pixel corresponding regions 131, 132, 133, and 134, the degree of deviation between the first layer LE1 and the second layer LE2 may be different from each other in at least two of the first to fourth pixel corresponding regions 131, 132, 133, and 134. In one peripheral group PG, the displacement in which the center of the arrangement of the entire second nanoposts NP2 and the center of the arrangement of the entire first nanoposts NP1 included in each of the first to fourth pixel corresponding regions 131, 132, 133, and 134 are out of line with each other in a direction perpendicular to the third direction (Z-direction) may be defined as first to fourth displacements. At least two of the first to fourth displacements may be different from each other. This will be described in detail later with reference to FIGS. 7A and 7B.

FIGS. 7A and 7B are cross-sectional views, seen from different cross-sections, of a pixel array in an image sensor according to an embodiment, and are conceptual diagrams for describing arrangement of nanoposts in a pixel corresponding group included in a peripheral group.

In the cross-sectional views of FIGS. 7A and 7B, the color separating lens array 130 is shown as an example in the peripheral group PG, from among the peripheral groups PG shown in FIG. 6, located at a position of which the azimuth $\varphi$ is greater than 90° and less than 270°, that is, the peripheral group PG located at the left side of the central group CG, but the descriptions provided hereinafter may be applied to the peripheral groups having a certain azimuth $\varphi$ and the CRA. In FIGS. 7A and 7B, the details of the nanoposts included in the first layer LE1 and the second layer LE2 of the color separating lens array 130 are omitted, and relative arrangements between the first to fourth regions 131, 132, 133, and 134 and the first to fourth pixels 111, 112, 113, and 114 facing each other and the relative arrangement relationship between the first layer LE1 and the second layer LE2 in each of the first to fourth regions 131, 132, 133, and 134 are described conceptually.

The entire first nanoposts NP1 arranged in the first layer LE1 of the first pixel corresponding region 131 are referred to as 131_NP1, the entire second nanoposts NP2 arranged in the second layer LE2 of the first pixel corresponding region 131 are referred to as 131_NP2, the entire first nanoposts NP1 arranged in the first layer LE1 of the second pixel corresponding region 132 are referred to as 132_NP1, the entire second nanoposts NP2 arranged in the second layer LE2 of the second pixel corresponding region 132 are referred to as 132_NP2, the entire first nanoposts NP1 arranged in the first layer LE1 of the third pixel corresponding region 133 are referred to as 133_NP1, the entire second nanoposts NP2 arranged in the second layer LE2 of the third pixel corresponding region 133 are referred to as 133_NP2, the entire first nanoposts NP1 arranged in the first layer LE1 of the fourth pixel corresponding region 134 are referred to as 134_NP1, and the entire second nanoposts NP2 arranged in the second layer LE2 of the fourth pixel corresponding region 134 are referred to as 134_NP2.

The center of the arrangement of the nanoposts in each of the first to fourth pixel corresponding regions 131, 132, 133, and 134 is not aligned with the center of the corresponding first to fourth pixels 111, 112, 113, and 114, and the degree of deviation may be expressed by displacement Q. Q may be expressed as a vector having a direction and a magnitude. When Q is determined, the distance ds between the color separating lens array 130 and the sensor substrate 110 and the refractive index of the material provided between the color separating lens array 130 and the sensor substrate 110 described above may be considered. Q is dependent upon the location of the peripheral group, that is, the azimuth $\varphi$ and the CRA, and there is no difference according to color of pixels. For example, positions of the first to fourth pixel corresponding regions 131, 132, 133, and 134 included in one peripheral group are defined by the azimuth $\varphi$ and the CRA at the center location of the corresponding peripheral group, and when Q is determined, there is no difference between the first to fourth pixel corresponding regions 131, 132, 133, and 134 in the magnitude or direction of Q. The direction of Q may be expressed as $(-a*\cos\varphi - b*\sin\varphi)$, when a and b are unit vectors of the first direction (X-direction) and the second direction (Y-direction). The magnitude of Q may be in proportional to (CRA/CRA_max). CRA_max denotes a maximum value of the CRA of the CR incident on the color separating lens array 130. There is no difference in a proportional constant associated with the magnitude of Q among the first to fourth pixel corresponding regions 131, 132, 133, and 134. The proportional constant associated with the magnitude of Q may vary depending on the location of the peripheral group.

The center of the entire arrangement of the second nanoposts NP2 in each of the first to fourth pixel corresponding regions 131, 132, 133, and 134 located in the second layer LE2 may not be aligned with the center of the entire arrangement of the first nanoposts NP1 in each of the first to fourth pixel corresponding regions 131, 132, 133, and 134 located in the first layer LE1. The degree of deviation may be expressed as first to fourth displacements S1, S2, S3, and S4.

The displacement of the center of the entire arrangement 131_NP2 of the second nanoposts NP2 arranged in the second layer LE2 of the first pixel corresponding region 131 from the center of the entire arrangement 131_NP1 of the first nanoposts NP1 arranged in the first layer LE1 of the first pixel corresponding region 131 is the first displacement S1.

The displacement of the center of the entire arrangement 132_NP2 of the second nanoposts NP2 arranged in the second layer LE2 of the second pixel corresponding region 132 from the center of the entire arrangement 132_NP1 of the first nanoposts NP1 arranged in the first layer LE1 of the second pixel corresponding region 132 is the second displacement S2.

The displacement of the center of the entire arrangement 133_NP2 of the second nanoposts NP2 arranged in the second layer LE2 of the third pixel corresponding region 133 from the center of the entire arrangement 133_NP1 of the first nanoposts NP1 arranged in the first layer LE1 of the third pixel corresponding region 133 is the third displacement S3.

The displacement of the center of the entire arrangement 134_NP2 of the second nanoposts NP2 arranged in the second layer LE2 of the fourth pixel corresponding region 134 from the center of the entire arrangement 134_NP1 of the first nanoposts NP1 arranged in the first layer LE1 of the fourth pixel corresponding region 134 is the fourth displacement S4.

The first to fourth displacements S1, S2, S3, and S4 may be expressed as vectors having magnitudes and directions. At least two of the first to fourth displacements S1, S2, S3, and S4 may be different from each other. For example, the first displacement S1 and the fourth displacement S4 may be equal to each other, and the third displacement S3 and the fourth displacement S4 may be different from the first displacement S1. The third displacement S3 and the fourth displacement S4 may be different from each other.

The first to fourth displacements S1, S2, S3, and S4 are dependent upon the azimuth φ and the CRA, and are each expressed as a vector sum of a common major displacement M and first to fourth minor displacements ms1, ms2, ms3, and ms4 as follows.

$$S1 = M + ms1 \qquad (1)$$

$$S2 = M + ms2 \qquad (2)$$

$$S3 = M + ms3 \qquad (3)$$

$$S4 = M + ms4 \qquad (4)$$

M denotes a vector and may be expressed by Equation 5 below.

$$M = C_M * (CRA/CRA\_max) * (-a * \cos\varphi - b * \sin\varphi) \qquad (5)$$

The major displacement may represent a primary or common movement vector in a particular direction, while the minor displacements are additional vectors that are added to the primary or common movement vector to fine-tune or adjust the overall displacement in the same or different directions. The minor displacements may be variations or adjustments made to the major displacement to account for specific factors or conditions.

Here, a and b are unit vectors of the first direction (X-direction) and the second direction (Y-direction), respectively and $C_M$ is a real number greater than 0.

M is dependent upon the azimuth φ and the CRA of the peripheral group PG, and the direction of M is toward the center axis of the color separating lens array 130. The center axis of the color separating lens array 130 denotes an axis passing the center C of the color separating lens array 130 and being in parallel to the third direction (Z-direction). A proportional constant $C_M$ may be determined in consideration of a distance d between the first layer LE1 and the second layer LE2 and a refractive index of a material included in the distance.

As described above, Equation 1 to Equation 5 are determined in consideration of the convenience in design for setting locations of the second nanoposts NP2 in the second layer LE2. After setting the positions of the second nanoposts NP2 of the second layer LE2 independent of the first to fourth pixel corresponding regions 131, 132, 133, and 134 based on Equation 5 above, a design method may be used to individually adjust the positions of the second nanoposts NP2 in each of the first to fourth pixel corresponding regions 131, 132, 133, and 134.

As described above, at least two of the first to fourth displacements S1, S2, S3, and S4 may be different from each other, and thus, at least two of the first to fourth minor displacements ms1, ms2, ms3, and ms4 may be different from each other. Three of the first to fourth minor displacements ms1, ms2, ms3, and ms4 may be different from one another, or all of the first to fourth minor displacements ms1, ms2, ms3, and ms4 may be different from one another.

As described above, adjusting the first to fourth minor displacements ms1, ms2, ms3, and ms4 is to reduce a channel difference occurring in pixels corresponding to the peripheral group as the CRA increases, as described above. Also, orders of the channel differences appearing in a plurality of channels (e.g., a red channel, a green channel, and a blue channel) in each of the first to fourth pixels 111, 112, 113, and 114 may be set to be similar by adjusting the first to fourth minor displacements ms1, ms2, ms3, and ms4. Along with the reduction in the channel difference, tendencies of the channel differences appearing in the plurality of channels in each of the first to fourth pixels 111, 112, 113, and 114 are formed to be similar so as to facilitate the image processing.

Hereinafter, examples of details for adjusting the first to fourth minor displacements ms1, ms2, ms3, and ms4 are described below.

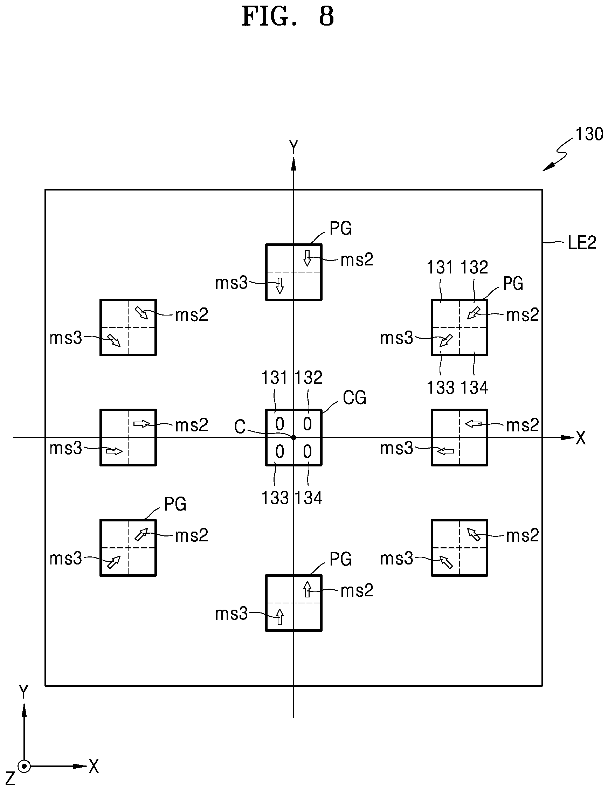

FIG. 8 is a plan view for describing examples of minor displacements applied to the second nanoposts NP2 of the second layer LE2 in the pixel corresponding group that is the peripheral group PG in various azimuths, in the color separating lens array 130 included in the pixel array 1100 of the image sensor according to the embodiment.

FIG. 8 shows directions of the second minor displacements ms2 and the third minor displacements ms3 at various azimuth positions of the peripheral groups PG.

The second minor displacement ms2 and the third minor displacement ms3 may be expressed as follows.

$$ms2 = C_2*(CRA/CRA\_max)*(-a*cos\varphi-b*sin\varphi) \qquad (6)$$

$$ms3 = C_3*(CRA/CRA\_max)*(-a*cos\varphi-b*sin\varphi) \qquad (7)$$

Here, a and b are unit vectors of the first direction (X-direction) and the second direction (Y-direction), respectively and $C_2$ and $C_3$ are real numbers greater than 0. $C_2$ and $C_3$ may be different from each other. $C_2$ may be greater than $C_3$. However, one or more embodiments are not limited thereto, and $C_2$ and $C_3$ may be equal to each other.

According to Equations 6 and 7 above, the magnitudes and directions of the second and third minor displacements ms2 and ms3 applied to the second and third pixel corresponding regions 132 and 133 included in the peripheral group PG may vary depending on the azimuth of the peripheral group PG. The directions of the second minor displacement ms2 and the third minor displacement ms3 proceed toward the center axis that passes through the center C of the color separating lens array 130 and is parallel to the third direction (Z-direction). The directions of the second and third minor displacements ms2 and ms3 are as expressed at various azimuths in FIG. 8.

In the embodiment, the magnitudes of the second minor displacement ms2 and the third minor displacement ms3 may be greater than the magnitude of the first minor displacement ms1 applied to the first pixel corresponding region 131 or the magnitude of the fourth minor displacement ms4 applied to the fourth pixel corresponding region 134. The first minor displacement ms1 may be equal to the fourth minor displacement ms4. The first minor displacement ms1 and the fourth minor displacement ms4 may be 0.

Assuming that the first and fourth minor displacements ms1 and ms4 are 0, the first and fourth minor displacements ms1 and ms4 may be expressed by equations below as vectors that are similar to the second and third minor displacements ms2 and ms3 and have less magnitudes.

$$ms1= C_1*(CRA/CRA\_max)*(-a*cos\varphi-b*sin\varphi) \qquad (8)$$

$$ms4= C_4*(CRA/CRA\_max)*(-a*cos\varphi-b*sin\varphi) \qquad (9)$$

In Equations 4 and 5 above, for example, $C_1=C_4<<C_2$, $C_3$ may be satisfied.

The first to fourth minor displacements ms1, ms2, ms3, and ms4 are described as displacements of the center of the entire arrangement of the second nanoposts NP2 with respect to the center of the entire arrangement of the first nanoposts NP1 in each of the first to fourth pixel corresponding regions 131, 132, 133, and 134.

The first to fourth minor displacements ms1, ms2, ms3, and ms4 may be described as follows, as a concept of difference between the relative positional relationship between the second nanoposts NP2 in the second layer LE2 in each of the first to fourth pixel corresponding regions 131, 132, 133, and 134 included in the peripheral group PG and the relative positional relationship between the second nanoposts NP2 in the second layer LE2 in each of the first to fourth pixel corresponding regions 131, 132, 133, and 134 included in the central group CG.

The first to fourth minor displacements ms1, ms2, ms3, and ms4 are applied only to the second nanoposts NP2 of the first to fourth pixel corresponding regions 131, 132, 133, and 134, which are located in the second layer LE2, in the peripheral group PG, and may not be applied to the first to fourth pixel corresponding regions 131, 132, 133, and 134 of the central group CG. Therefore, in the peripheral group PG, the relative positional relationship among the second nanoposts NP2 in each of the first to fourth pixel corresponding regions 131, 132, 133, and 134, which are located in the second layer LE2, is different from the relative positional relationship among the second nanoposts NP2 in each of the first to fourth pixel corresponding regions 131, 132, 133, and 134, which are located in the second layer LE2, in the central group CG. In other words, in the peripheral group PG, the relative positional relationship among the first nanoposts NP1 in each of the first to fourth pixel corresponding regions 131, 132, 133, and 134, which are located in the first layer LE1, is the same as the relative positional relationship among the first nanoposts NP1 in each of the first to fourth pixel corresponding regions 131, 132, 133, and 134, which are located in the first layer LE1, in the central group CG. The first to fourth minor displacements ms1, ms2, ms3, and ms4 are dependent upon the azimuth $\varphi$ and the CRA of the peripheral group PG, and thus, the difference in the relative positional relationship is also dependent upon the azimuth $\varphi$ and the CRA of the peripheral group PG.

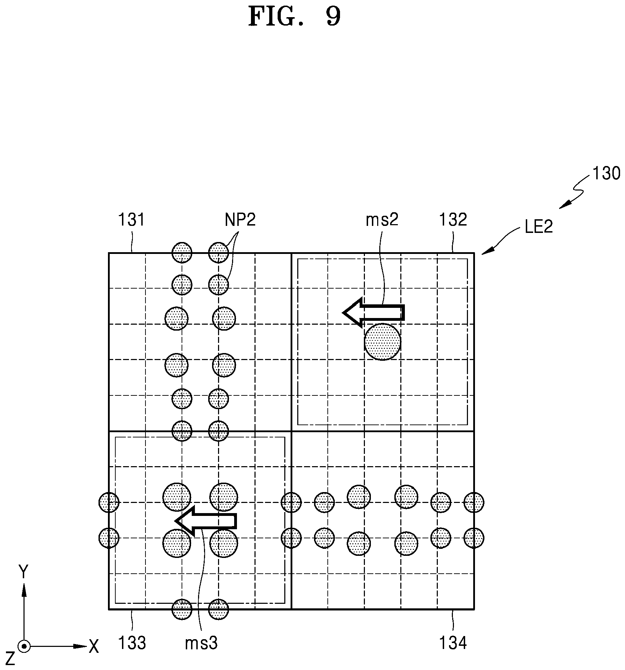

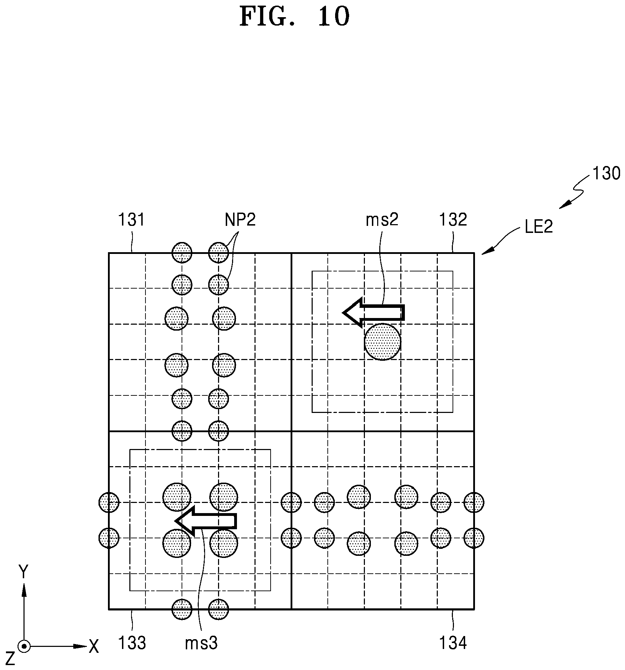

FIGS. 9 and 10 are plan views for describing relative positional relationship between the second nanoposts in the second layer of a pixel corresponding group that is a peripheral group, as compared with the relative positional relationship between the second nanoposts in the second layer of a pixel corresponding group that is a central group, in the color separating lens array included in the pixel array included in the image sensor according to the embodiment.

Detailed positions of the second nanoposts NP2 shown in the second layer LE2 of the color separating lens array 130 of FIG. 9 are shown with respect to the central group CG, and directions of the second and third minor displacements ms2 and ms3 indicated in the second pixel corresponding region 132 and the third pixel corresponding region 133 are examples of the peripheral group PG at the location having the azimuth of 0 from among the peripheral groups PG shown in FIG. 8. The relative positional relationship among the first to fourth pixel corresponding regions 131, 132, 133, and 134 in the second layer LE2 of the peripheral group PG is different from the relative positional relationship among the first to fourth pixel corresponding regions 131, 132, 133, and 134 in the central group CG, as much as the second and third minor displacements ms2 and ms3 indicated by the arrows.

The second nanoposts NP2 in the second layer LE2 of the second pixel corresponding region 132 in the peripheral group PG have position differences from the second nanoposts NP2 of the first green pixel corresponding region 131 and the fourth pixel corresponding region 134 as much as the second minor displacement ms2, as compared with the second nanoposts NP2 in the second layer LE2 of the second pixel corresponding region 132 in the central group CG. The second nanoposts NP2 in the second layer LE2 of the third pixel corresponding region 133 in the peripheral group PG have position differences from the second nanoposts NP2 of the first pixel corresponding region 131 and the fourth pixel corresponding region 134 as much as the third minor displacement ms3, as compared with the second nanoposts NP2 in the second layer LE2 of the third pixel corresponding region 133 in the central group CG.

When applying the minor displacement, an average of two minor displacements defined in two adjacent pixel corresponding regions may be applied to the second nanoposts NP2 located at the boundary between the pixel corresponding regions.

Alternatively, as shown in FIG. 10, the above minor displacement is not applied to the second nanoposts NP2 located at the boundary between the pixel corresponding regions, but may be applied only to some second nanoposts NP2 including the second nanoposts NP2 located at the centers of the second pixel corresponding region 132 and the third pixel corresponding region 133. The relative positional relationships of the second nanoposts NP2 located at the boundary of the second pixel corresponding region 132 in the peripheral group PG, with respect to the second nanoposts NP2 in the adjacent first pixel corresponding region 131 and to the second nanoposts NP2 in the adjacent fourth pixel corresponding region 134 may be the same as the relative positional relationships of the second nanoposts NP2 located at the boundary of the second pixel corresponding region 132 in the central group CG with respect to the second nanoposts NP2 in the adjacent first pixel corresponding region 131 and to the second nanoposts NP2 in the adjacent fourth pixel corresponding region 134, respectively.

Except for the second nanoposts NP2 located at the boundary of the second pixel corresponding region 132 in the peripheral group PG, the second nanoposts NP2 in the second layer LE2 of the second pixel corresponding region 132 in the peripheral group PG have relative position differences from the second nanoposts NP2 in the first pixel corresponding region 131 and the fourth pixel corresponding region 134 as much as the second minor displacement ms2, as compared with the second nanoposts NP2 in the second layer LE2 of the second pixel corresponding region 132 in the central group CG. Except for the second nanoposts NP2 located at the boundary of the second pixel corresponding region 132 in the peripheral group PG, the second nanoposts NP2 in the second layer LE2 of the third pixel corresponding region 133 in the peripheral group PG have relative position differences from the second nanoposts NP2 in the first pixel corresponding region 131 and the fourth pixel corresponding region 134 as much as the third minor displacement ms3, as compared with the second nanoposts NP2 in the second layer LE2 of the third pixel corresponding region 133 in the central group CG.

The magnitudes of the second and third minor displacements ms2 and ms3 in this case may be different from those of the second and third minor displacements ms2 and ms3 described with reference to FIG. 9. In other words, the second and third minor displacements ms2 and ms3 are expressed as Equations 6 and 7 above, and the proportional constant included in the equations may be different from those of FIG. 10.

The above description is exemplary, and setting of detailed positions of the second nanoposts NP2 in the second layer LE2 in the peripheral group PG may vary by appropriately adjusting the proportional constant for convenience of design, while applying the rules as in Equations 6 to 9. For example, the constants included in Equations above may be set to represent the desired channel difference at the position where the CRA has maximum value. In addition, the order of channel differences appearing in the plurality of channels of each of the first to fourth pixels 111, 112, 113, and 114 may be set to be as similar as possible. The combination of the above constants is not limited to one example, but may have various combinations. The above equations are examples and may be changed. For example, the suggested minor displacements are linearly in proportional to the CRA, but are not limited thereto, and may be in proportional in another functional relationship, e.g., a non-linear relationship.

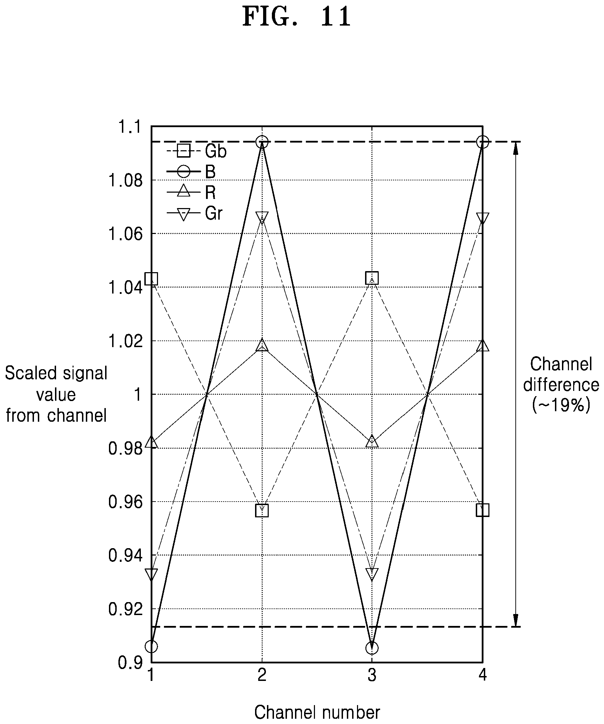

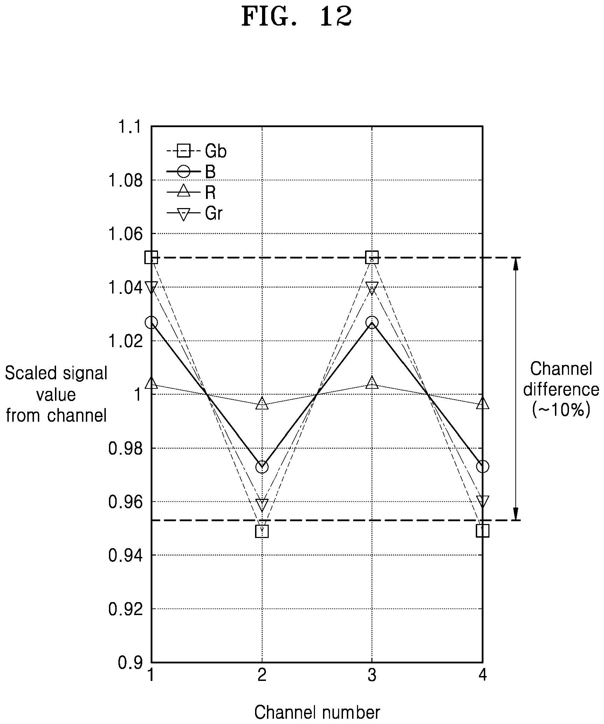

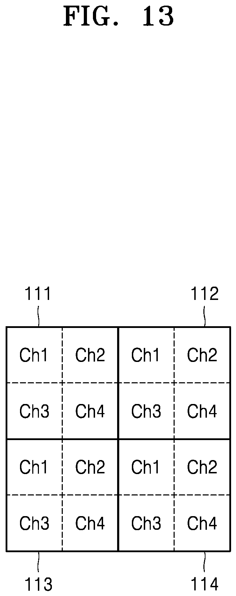

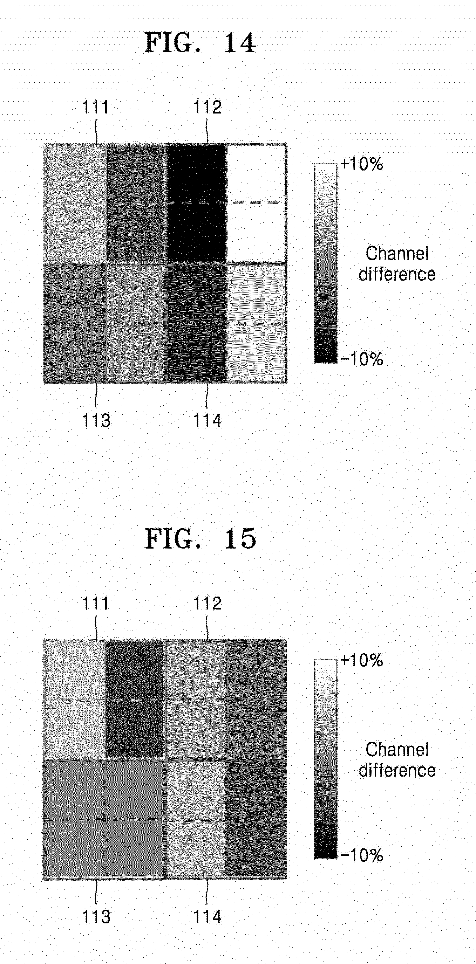

FIGS. 11 and 12 are graphs showing examples of channel differences occurring in the image sensors according to a comparative example and an embodiment, FIG. 13 is a plan view showing an arrangement of channels represented in the graphs, and FIGS. 14 and 15 are distributions showing the channel differences appearing in the image sensors according to the comparative example and the embodiment in the channel regions.

In the embodiment and the comparative example, the first pixel 111, the second pixel 112, the third pixel 113, and the fourth pixel 114 are respectively a green pixel Gb, a blue pixel B, a red pixel R, and a green pixel Gr. The comparative example is an example to which the minor displacement is not applied, that is, the first to fourth minor displacements ms1, ms2, ms3, and ms4 in the above description are 0. The embodiment is an example in which the second minor displacement ms2 is 100 nm in +X direction, the third minor displacement ms3 is 80 nm in +X direction, the first minor displacement ms1 is 0, and the fourth minor displacement ms4 is 0. That is, in the embodiment, the center of arrangement of the second nanoposts NP2 in the second layer LE2 of the second pixel corresponding region 132 is shifted by 100 nm in the +X direction from the center of the arrangement of the first nanoposts NP1 in the first layer LE1, and the center of arrangement of the second nanoposts NP2 in the second layer LE2 of the third pixel corresponding region 133 is shifted by 60 nm in the +X direction from the center of the arrangement of the first nanoposts NP1 in the first layer LE1.

A numerical value 1 indicated on the longitudinal axis is a reference value, for example, may be a signal value from one channel in the pixel corresponding to the central group CG. When comparing FIG. 11 with FIG. 12, the maximum value of the channel difference is reduced from about 19% to about 10%.

In the distributions of FIGS. 14 and 15, the channel difference is the difference based on a signal value 1, expressed in %. In FIG. 14 according to the comparative example, the orders of the channel differences occurring in the first to fourth pixels 111, 112, 113, and 114 are different from one another. Also, the order of the channel differences appearing in the first pixel 111 and the order of the channel differences appearing in the fourth pixel 114 are clearly different from each other. In FIG. 15 according to the embodiment, the orders of the channel differences occurring in the first to fourth pixels 111, 112, 113, and 114 are similar to one another. The orders of the channel differences appearing in the first pixel 111 and the fourth pixel 114 are equal to each other. Also, in each of the first to fourth pixels 111, 112, 113, and 114, channel difference values in ch1 and ch3 are nearly the same as each other, and the channel difference values in ch2 and ch4 are nearly the same as each other. Considering this, the order of the channel differences is nearly the same in each of the first to fourth pixels 111, 112, 113, and 114. The graphs in FIGS. 11 and 12 are about the peripheral group PG at the position where the azimuth is 0°. In addition, in a case having different azimuth, e.g., about 45°, the orders of channel differences appearing in the first to fourth pixels 111, 112, 113, and 114 may not be all the same, but in at least two pixels, the orders may be equal to each other. The at least two pixels may include, for example, two green pixels Gr and Gb. However, one or more embodiments are not limited to the above example.

As described above with reference to the comparative example and the embodiment, by applying the minor displacements to the second nanoposts NP2 in the second layer LE2, the maximum value of the channel difference is reduced and the orders of the channel differences appearing in the first to fourth pixels 111, 112, 113, and 114 are similar to one another. The orders of the channel differences appearing in the first to fourth pixels 111, 112, 113, and 114 may be the same in at least two pixels, or the minor displacements may be set so that the orders are the same in the first to fourth pixels 111, 112, 113, and 114. Along with the reduction in the channel difference as described above, tendencies of the channel differences appearing in the plurality of channels in each of the first to fourth pixels 111, 112, 113, and 114 are formed to be similar so as to facilitate the image processing. Also, the same order of the channel differences in the first pixel 111 and the fourth pixel 114 corresponding to the two green pixels Gb and Gr is clearly different from the comparative example, and thereby facilitating the image processing.

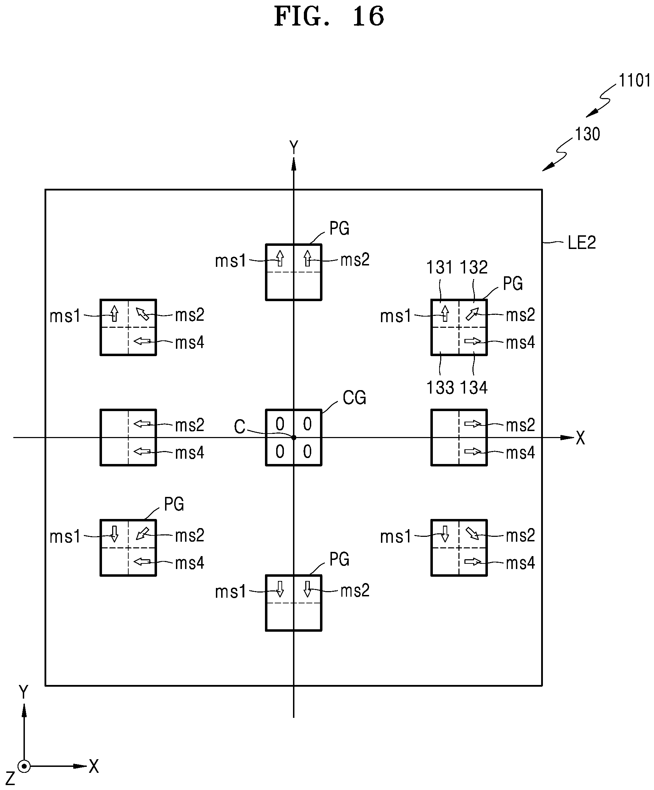

FIG. 16 is a plan view for describing examples of fine displacements of second nanoposts in a second layer in each of pixel corresponding groups included in the peripheral group at various azimuth positions, in a color separating lens array included in a pixel array of an image sensor according to another embodiment.

In the embodiment, the first to fourth displacements S1, S2, S3, and S4 defined in the above descriptions with reference to FIGS. 7A and 7B satisfy Equations 1 to 5 above, but details of the first to fourth minor displacements ms1, ms2, ms3, and ms4 are different from the descriptions with reference to FIGS. 8 to 10, that is, Equations 6 to 9 above.

FIG. 16 shows directions of the first minor displacement ms1, the second minor displacements ms2, and the fourth minor displacements ms4 at various azimuth positions of the peripheral groups PG.

The first minor displacement ms1, the second minor displacement ms2 and the fourth minor displacement ms4 may be expressed as follows.

$$ms1 = D_1*(CRA/CRA\_max)*b*\sin\varphi \qquad (10)$$

$$ms2 = D_{3b}*(CRA/CRA\_max)*b*\sin\varphi + D_{3a}*(CRA/CRA\_max)*a*\cos\varphi \qquad (11)$$

$$ms4 = D_4*(CRA/CRA\_max)*a*\cos\varphi \qquad (12)$$

Here, a and b are unit vectors of the first direction (X-direction) and the second direction (Y-direction), respectively and $D_1$, $D_4$, $D_{3b}$, and $D_{3a}$ are real numbers greater than 0. At least two of $D_1$, $D_4$, $D_{3b}$, and $D_{3a}$ may be different from each other.

In the embodiment, the third minor displacement ms3 may be 0.

According to Equations 10, 11, and 12 above, the magnitudes and directions of the first, second, and fourth minor displacements ms1, ms2, and ms4 applied to the first, second, and fourth pixel corresponding regions 131, 132, and 134 included in the peripheral group PG may vary depending on the azimuth of the peripheral group PG. The second minor displacement ms2 is in a direction away from the center axis that passes the center C of the color separating lens array 130 and is parallel to the third direction (Z direction), the first minor displacement ms1 is in a direction away from the axis that passes the center C of the color separating lens array 130 and is parallel to the first direction (X direction), and the fourth minor displacement ms1 is in a direction away from the axis that passes the center C of the color separating lens array 130 and is parallel to the second direction (Y direction). The directions of the first, second, and fourth minor displacements ms1, ms2, and ms4 are as expressed from various azimuth angles in FIG. 16.

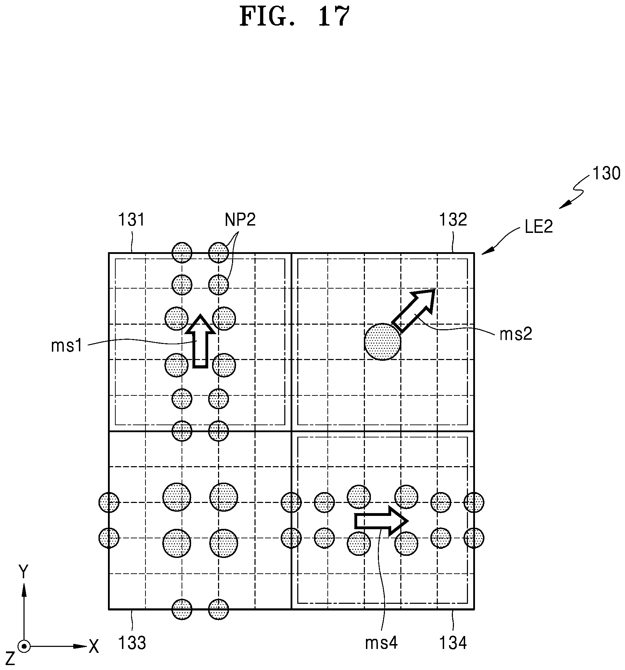

FIGS. 17 to 19 are plan views for describing relative positional relationship between second nanoposts in a second layer in a pixel corresponding group that is a peripheral group, as compared with the relative positional relationship between two-layers of nanoposts in a pixel corresponding group that is a central group, in the color separating lens array included in the pixel array included in the image sensor according to the embodiment.

Detailed positions of the second nanoposts NP2 shown in the second layer LE2 of the color separating lens array 130 of FIG. 17 are shown with respect to the central group CG, and directions of the first, second, and fourth minor displacements ms1, ms2, and ms4 indicated in the first pixel corresponding region 131, the second pixel corresponding region 132, and the fourth pixel corresponding region 134 are examples of the peripheral group PG at the location having the azimuth of 0° to 90° from among the peripheral groups PG shown in FIG. 16. The relative positional relationship among the first to fourth pixel corresponding regions 131, 132, 133, and 134 in the second layer LE2 of the peripheral group PG is different from the relative positional relationship among the first to fourth pixel corresponding regions 131, 132, 133, and 134 in the central group CG, as much as the first, second, and fourth minor displacements ms1, ms2, and ms4 indicated by the arrows.

The second nanoposts NP2 in the second layer LE2 of the first pixel corresponding region 131 in the peripheral graph PG may have relative positional differences with respect to the second nanoposts NP2 in the third pixel corresponding region 133 as much as the first minor displacement ms1, as compared with the second nanoposts NP2 in the second layer LE2 of the first pixel corresponding region 131 in the central group CG. The second nanoposts NP2 in the second layer LE2 of the second pixel corresponding region 132 in the peripheral graph PG may have positional differences with respect to the second nanoposts NP2 in the third pixel corresponding region 133 as much as the second minor displacement ms2, as compared with the second nanoposts NP2 in the second layer LE2 of the second pixel corresponding region 132 in the central group CG. The second nanoposts NP2 in the second layer LE2 of the fourth pixel corresponding region 134 in the peripheral graph PG may have positional differences with respect to the second nanoposts NP2 in the third pixel corresponding region 133 as much as the fourth minor displacement ms4, as compared with the second nanoposts NP2 in the second layer LE2 of the fourth pixel corresponding region 134 in the central group CG.

When applying the minor displacement, an average of two minor displacements defined in two adjacent pixel corresponding regions may be applied to the second nanoposts NP2 located at the boundary between the pixel corresponding regions.

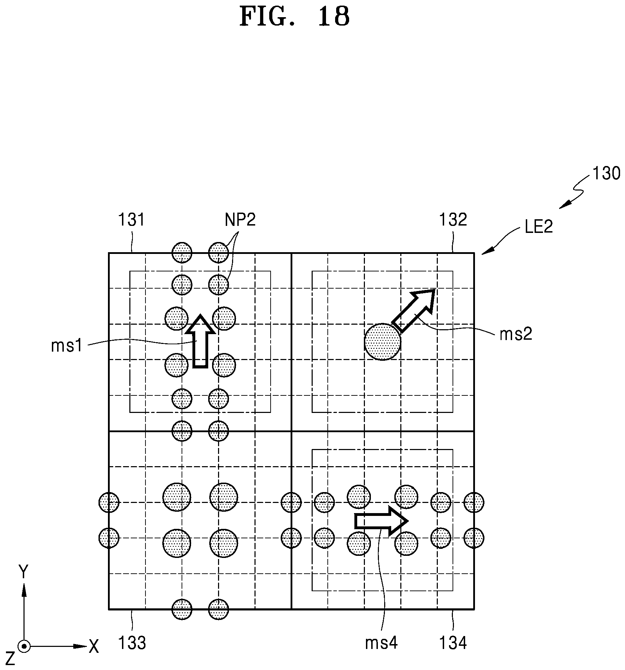

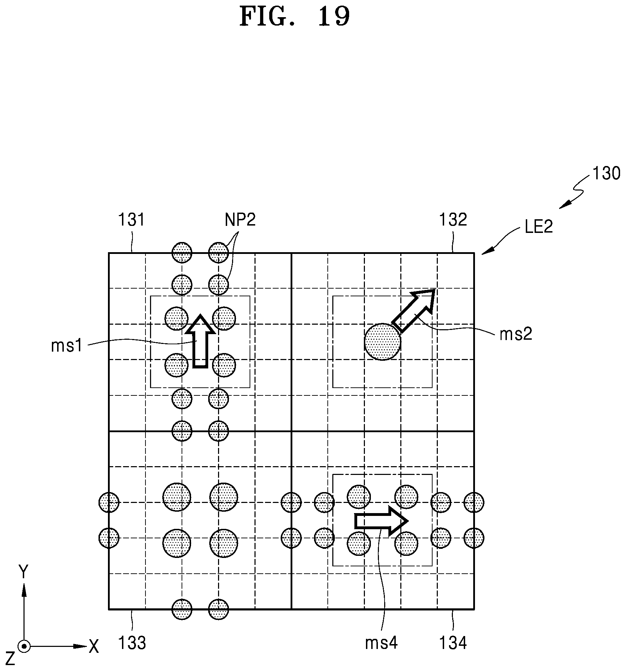

Alternatively, as shown in FIGS. 18 and 19, the above-described minor displacements may be applied only to some second nanoposts NP2 including the second nanoposts NP2 located at the centers of the first, second, and fourth pixel corresponding regions 131, 132, and 134.

FIG. 18 shows that the minor displacement may not be applied to the second nanoposts NP2 located at the boundaries between the pixel corresponding regions. The relative positional relationship of the second nanoposts NP2 located at the boundary between the pixel corresponding regions in the peripheral group PG with respect to the second nanoposts NP2 in the third pixel corresponding region 133 may be equal to the relative positional relationship of the second nanoposts NP2 in the second layer LE2 located at the boundary between the pixel corresponding regions in the central group CG with respect to the second nanoposts NP2 in the second layer LE2 of the third pixel corresponding region 133.

Except for the second nanoposts NP2 in the second layer LE2, which are located at the boundary of the first pixel corresponding region 131 in the peripheral group PG, the second nanoposts NP2 in the second layer LE2 of the first pixel corresponding region 131 in the peripheral group PG have positional differences from the second nanoposts NP2 in the second layer LE2 of the third pixel corresponding region 133 as much as the first minor displacement ms1, as compared with the nanoposts NP2 in the second layer LE2 of the first pixel corresponding region 131 in the central group CG. Except for the second nanoposts NP2 located at the boundary of the second pixel corresponding region 132 in the peripheral group PG, the second nanoposts NP2 in the second layer LE2 of the second pixel corresponding region 132 in the peripheral group PG have relative position differences from the second nanoposts NP2 in the second layer LE2 of the third pixel corresponding region 133 as much as the third minor displacement ms3, as compared with the second nanoposts NP2 in the second layer LE2 of the second pixel corresponding region 132 in the central group CG. Except for the second nanoposts NP2 located at the boundary of the fourth pixel corresponding region 134 in the peripheral group PG, the second nanoposts NP2 in the second layer LE2 of the fourth pixel corresponding region 134 in the peripheral group PG have relative position differences from the second nanoposts NP2 of the third pixel corresponding region 133 as much as the fourth minor displacement ms4, as compared with the second nanoposts NP2 in the second layer LE2 of the fourth pixel corresponding region 134 in the central group CG.

In this case, the magnitudes of the first minor displacement ms1, the second minor displacement ms2, and the fourth minor displacement ms4 may be different from those of the first minor displacement ms1, the second minor displacement ms2, and the fourth minor displacement ms4 described above with reference to FIG. 17. In other words, the first, second, and fourth minor displacements ms1, ms2, and ms4 are expressed as Equations 10 to 12 above, and the proportional constants included in the equations may be different from those of FIG. 17.

FIG. 19 is different from the example of FIG. 18 in that the positions of the second nanoposts NP2, to which the first, second, and fourth minor displacements ms1, ms2, and ms4 are applied, are limited to smaller regions at the centers of the first pixel corresponding region 131, the second pixel corresponding region 132, and the fourth pixel corresponding region 134.

In the above descriptions with reference to FIGS. 7A to 19, when the first to fourth displacements S1, S2, S3, and S4 representing the degree of deviation between the arrangement center of the first nanoposts NP1 and the arrangement center of the second nanoposts NP2 in each of the first to fourth pixel corresponding regions 131, 132, 133, and 134 are described, the first to fourth minor displacements ms1, ms2, ms3, and ms4 included in each of the first to fourth displacements S1, S2, S3, and S4 are applied to the second nanoposts NP2 in the second layer LE2 of the peripheral group PG

In another embodiment, the minor displacements may be applied to the first nanoposts NP1 in the first layer LE1 of the central group CG, not the second nanoposts NP2 in the second layer LE2 of the peripheral group PG. In the embodiment, in the peripheral group PG, the relative positional relationship among the second nanoposts NP2 in each of the first to fourth pixel corresponding regions 131, 132, 133, and 134, which are located in the first layer LE1, may be different from the relative positional relationship among the first nanoposts NP1 in each of the first to fourth pixel corresponding regions 131, 132, 133, and 134, which are located in the first layer LE1, in the central group CG. In this case, in the peripheral group PG, the relative positional relationship among the second nanoposts NP2 in each of the first to fourth pixel corresponding regions 131, 132, 133, and 134, which are located in the second layer LE2, may be the same as the relative positional relationship among the second nanoposts NP2 in each of the first to fourth pixel corresponding regions 131, 132, 133, and 134, which are located in the second layer LE2, in the central group CG.

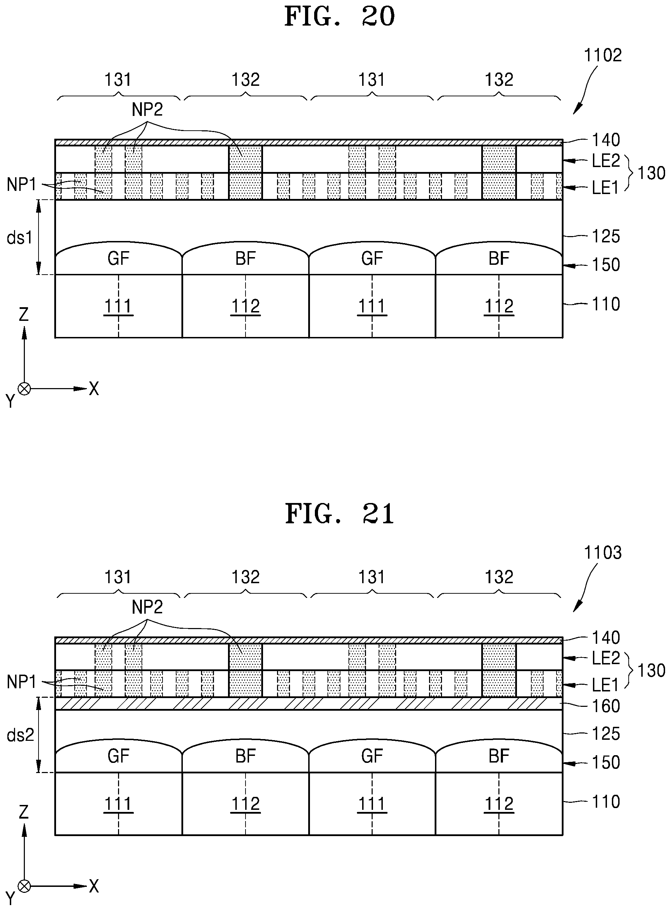

FIGS. 20 to 23 are cross-sectional views schematically showing an image sensor pixel array according to some embodiments.

Referring to FIG. 20, an image sensor pixel array 1102 may further include a color filter array 150 that is arranged between the sensor substrate 110 and the color separating lens array 130 and includes a green filter GF, a blue filter BF, and a red filter. The filters included in the color filter array 150 may be arranged, for example, in a shape corresponding to the color arrangement as shown in FIG. 2A. Because the color separating lens array 130 performs the color separation in the embodiment, adding of the color filter array may improve a color purity by supplementing some errors that may occur during the color separation of the color separating lens array 130. A planarization layer 125 covering the color filter array 150 may be provided on the color filter array 150. A distance ds1 between the color separating lens array 130 and the sensor substrate 110 may be appropriately set according to the refractive index of the color filter array 150 and the planarization layer 125. An anti-reflection layer 140 may be provided on the color separating lens array 130.

A pixel array 1103 of FIG. 21 is different from the pixel array 1102 of FIG. 20, in that an encapsulation layer 160 is further provided between the planarization layer 125 and the color separating lens array 130. The refractive index of the encapsulation layer 160 may be different from the refractive index of the planarization layer 125. A distance ds2 between the color separating lens array 130 and the sensor substrate 110 may be appropriately set according to the refractive index of the color filter array 150, the planarization layer 125, and the encapsulation layer 160.

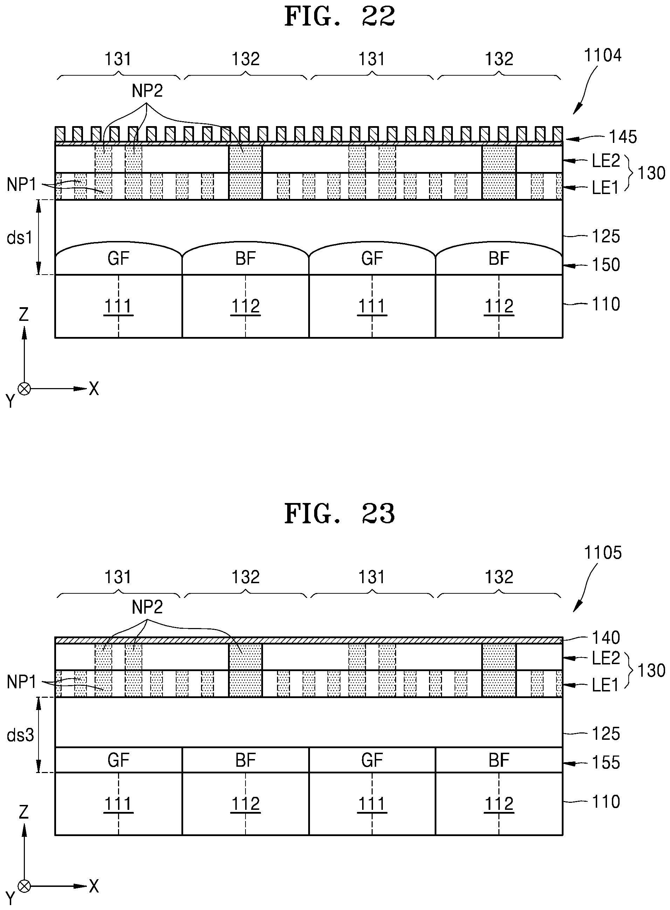

A pixel array 1104 of FIG. 22 is different from the pixel array 1102 of FIG. 20 in that the anti-reflection layer 145 includes a nano-structure.

A pixel array 1105 of FIG. 23 is different from the pixel array 1102 of FIG. 20 in that a color filter array 155 includes an inorganic material. A distance ds3 between the color separating lens array 130 and the sensor substrate 110 may be set according to the refractive index of the color filter array 155.

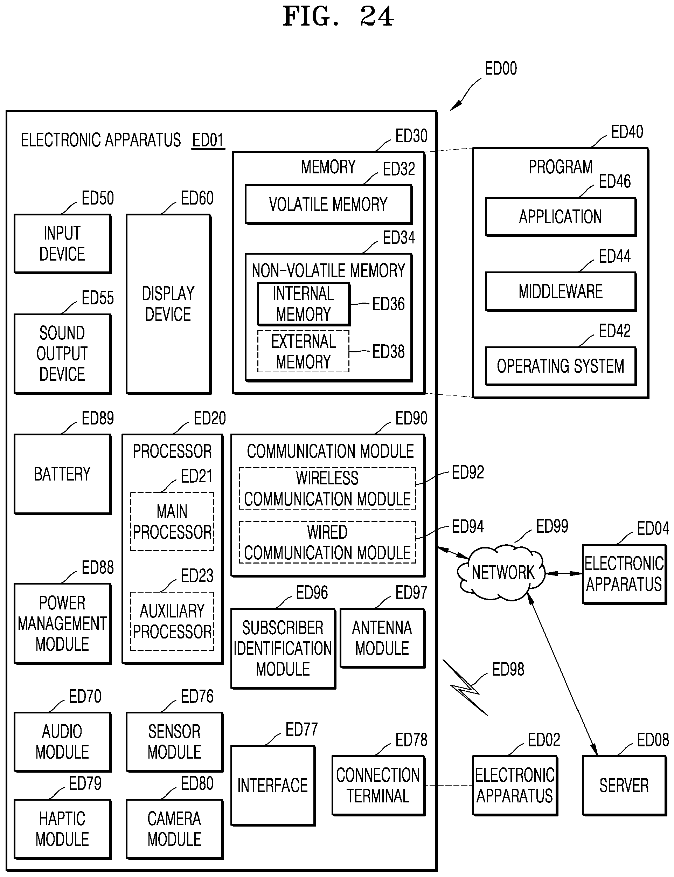

FIG. 24 is a block diagram of an electronic apparatus including an image sensor according to some embodiments. Referring to FIG. 24, in a network environment ED00, an electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.) The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.).

The processor ED20 may control one or more elements (hardware, software elements, etc.) of the electronic apparatus ED01 connected to the processor ED20 by executing software (program ED40, etc.), and may perform various data processes or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The processor ED20 may include a main processor ED21 (central processing unit, application processor, etc.) and an auxiliary processor ED23 (graphic processing unit, image signal processor, sensor hub processor, communication processor, etc.) that may be operated independently from or along with the main processor ED21. The auxiliary processor ED23 may use less power than that of the main processor ED21, and may perform specific functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (display device ED60, sensor module ED76, communication module ED90, etc.) of the elements in the electronic apparatus ED01. The auxiliary processor ED23 (image signal processor, communication processor, etc.) may be implemented as a part of another element (camera module ED80, communication module ED90, etc.) that is functionally related thereto.

The memory ED30 may store various data required by the elements (processor ED20, sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30, and may include an operation system ED42, middleware ED44, and/or an application ED46.

The input device ED50 may receive commands and/or data to be used in the elements (processor ED20, etc.) of the electronic apparatus ED01, from outside (user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include a touch circuitry set to sense a touch, and/or a sensor circuit (pressure sensor, etc.) that is set to measure a strength of a force generated by the touch.

The audio module ED70 may convert sound into an electrical signal or vice versa. The audio module ED 70 may acquire sound through the input device ED50, or may output sound via the sound output device ED55 and/or a speaker and/or a headphone of another electronic apparatus (electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.), and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (electronic apparatus ED02, etc.) The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (electronic apparatus ED02, etc.). The connection terminal ED78 may include an HDMI connector, a USB connector, an SD card connector, and/or an audio connector (headphone connector, etc.).

The haptic module ED79 may convert the electrical signal into a mechanical stimulation (vibration, motion, etc.) or an electric stimulation that the user may sense through a tactile or motion sensation. The haptic module ED79 may include a motor, a piezoelectric device, and/or an electric stimulus device.

The camera module ED80 may capture a still image and a video. The camera module ED80 may include a lens assembly including one or more lenses, the image sensor 1000 described above, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (electronic apparatus ED02, electronic apparatus ED04, server ED08, etc.), and execution of communication through the established communication channel. The communication module ED90 may be operated independently from the processor ED20 (application processor, etc.), and may include one or more communication processors that support the direct communication and/or the wireless communication. The communication module ED90 may include a wireless communication module ED92 (cellular communication module, a short-range wireless communication module, a global navigation satellite system (GNSS) communication module) and/or a wired communication module ED94 (local area network (LAN) communication module, a power line communication module, etc.). From among the communication modules, a corresponding communication module may communicate with another electronic apparatus via a first network ED09 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

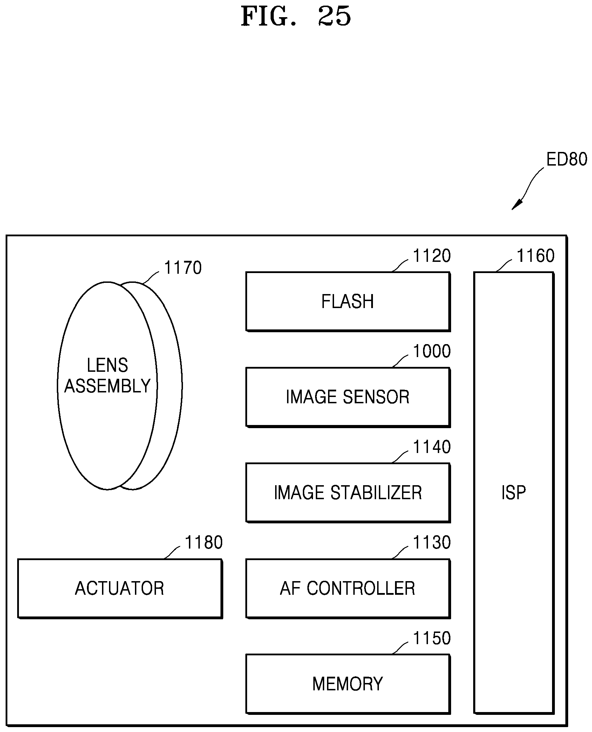

FIG. 25 is a block diagram showing an example of the camera module ED80 included in the electronic apparatus ED01 of FIG. 24. Referring to FIG. 25, the camera module ED80 may include a lens assembly 1170, a flash 1120, an image sensor 1000, an image stabilizer 1140, an AF controller 1130, a memory 1150 (buffer memory, etc.), an actuator 1180, and/or an image signal processor (ISP) 1160.

The lens assembly 1170 may collect light emitted from an object that is to be captured. The lens assembly 1170 may include one or more optical lenses. The lens assembly 1170 may include a path switching member which switches the optical path toward the image sensor 1000. According to whether the path switching member is provided and the arrangement type with the optical lens, the camera module ED80 may have a vertical type or a folded type. The camera module ED80 may include a plurality of lens assemblies 1170, and in this case, the camera module ED80 may include a dual camera module, a 360-degree camera, or a spherical camera. Some of the plurality of lens assemblies 1170 may have the same lens properties (viewing angle, focal distance, auto-focus, F number, optical zoom, etc.) or different lens properties. The lens assembly 1170 may include a wide-angle lens or a telephoto lens.

The actuator 1180 may drive the lens assembly 1170. At least some of the optical lens and the path switching member included in the lens assembly 1170 may be moved by the actuator 1180. The optical lens may be moved along the optical axis, and when the distance between adjacent lenses is adjusted by moving at least some of the optical lenses included in the lens assembly 1170, an optical zoom ratio may be adjusted.

The actuator 1180 may adjust the position of any one of the optical lenses in the lens assembly 1170 so that the image sensor 1000 may be located at the focal length of the lens assembly 1170. The actuator 1180 may drive the lens assembly 1170 according to an AF driving signal transferred from the AF controller 1130.

The flash 1120 may emit light that is used to strengthen the light emitted or reflected from the object. The flash 1120 may emit visible light or infrared-ray light. The flash 1120 may include one or more light-emitting diodes (red-green-blue (RGB)) LED, white LED, infrared LED, ultraviolet LED, etc.), and/or a Xenon lamp. The image sensor 1000 may be the image sensor 1000 described above with reference to FIG. 1 and may include the above-described pixel arrays 1101, 1102, 1103, 1104, and 1105 or a pixel array in the form of a combination or modification thereof. The image sensor 1000 may obtain an image corresponding to a subject by converting the light emitted or reflected from the subject and transferred through the lens assembly 1170 into an electrical signal.

The image sensor 1000 includes the color separating lens array 130 described above, and each pixel may include a plurality of photosensitive cells forming a plurality of channels, for example, the plurality of photosensitive cells arranged in a 2x2 array. Some of the pixels may be used as AF pixels, and the image sensor 1000 may generate an AF driving signal from the signals from the plurality of channels in the AF pixels. The nanoposts of the color separating lens array included in the image sensor 1000 are arranged in two-layers as described above, and the arrangement type of the nanoposts arranged in the second layer is adjusted so that the channel difference may be reduced and the tendencies of the channel differences may be similar between the pixels of different colors. Thus, the accuracy in the AF driving may be improved.

The image stabilizer 1140, in response to a motion of the camera module ED80 or the electronic apparatus ED01 including the camera module ED80, moves one or more lenses included in the lens assembly 1170 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor or an acceleration sensor disposed in or out of the camera module ED80. The image stabilizer 1140 may be implemented as an optical type.

The AF controller 1130 may generate the AF driving signal from signal values sensed from the AF pixels in the image sensor 1000. The AF controller 1130 may control the actuator 1180 according to the AF driving signal.

The memory 1150 may store some or entire data of the image obtained through the image sensor 1000 for subsequent image processing operations. For example, when a plurality of images are obtained at a high speed, obtained original data (Bayer-patterned data, high-resolution data, etc.) is stored in the memory 1150, and only a low-resolution image is displayed. Then, original data of a selected image (user selection, etc.) may be transferred to the image signal processor 1160. The memory 1150 may be integrated with the memory ED30 of the electronic apparatus ED01, or may include an additional memory that is operated independently.

The ISP 1160 may perform image processing on the image obtained through the image sensor 1000 or the image data stored in the memory 1150. The image processing may include a depth map generation, three-dimensional modeling, panorama generation, extraction of features, image combination, and/or image compensation (noise reduction, resolution adjustment, brightness adjustment, blurring, sharpening, softening, etc.) The image signal processor 1160 may perform controlling (exposure time control, read-out timing control, etc.) of the elements (image sensor 1000, etc.) included in the camera module ED80. The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes an additional image processing by the processor ED20 and then may be displayed on the display device ED60.

The AF controller 1130 may be integrated with the image signal processor 1160. The image signal processor 1160 may generate the AF signal by processing signals from the AF pixels of the image sensor 1000, and the AF controller 1130 may convert the AF signal into a driving signal of the actuator 1180 and transfer the signal to the actuator 1180.

The electronic apparatus ED01 may further include one or a plurality of camera modules having different properties or functions. The camera module may include elements similar to those of the camera module ED80 of FIG. 24, and the image sensor included in the camera module may be implemented as a charge coupled device (CCD) sensor and/or a complementary metal oxide semiconductor (CMOS) sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

The image sensors according to the embodiments may be applied to various electronic apparatuses.

The image sensor 1000 according to the embodiments may be applied to a mobile phone or a smartphone, a tablet or a smart tablet, a digital camera or a camcorder, a laptop computer, or a television or a smart television. For example, the smartphone or the smart tablet may include a plurality of high-resolution cameras each including a high-resolution image sensor. Depth information of objects in an image may be extracted, out focusing of the image may be adjusted, or objects in the image may be automatically identified by using the high-resolution cameras.

Also, the image sensor 1000 may be applied to a smart refrigerator, a surveillance camera, a robot, a medical camera, etc. For example, the smart refrigerator may automatically recognize food in the refrigerator by using the image sensor, and may notify a user of the existence of a certain kind of food, kinds of food put into or taken out, etc. through a smartphone. Also, the surveillance camera may provide an ultra-high-resolution image and may allow the user to recognize an object or a person in the image even in a dark environment by using high sensitivity. The robot may be input to a disaster or industrial site that a person may not directly access, to provide the user with high-resolution images. The medical camera may provide high-resolution images for diagnosis or surgery, and may dynamically adjust a field of view.

Also, the image sensor 1000 may be applied to a vehicle. The vehicle may include a plurality of vehicle cameras arranged at various positions, and each of the vehicle cameras may include the image sensor according to the embodiment. The vehicle may provide a driver with various information about the inside of the vehicle or periphery of the vehicle by using the plurality of vehicle cameras, and may also provide the driver with information required for autonomous driving by automatically recognizing an object or a person in the image.

Because the color separating lens array included in the image sensor described above may separate the incident light by wavelengths and condense the separated light without absorbing or blocking the incident light, the light utilization efficiency of an image sensor may be improved.

Also, the nanoposts of the color separating lens array are designed considering the light that is slantly incident on the periphery portion of the image sensor, and thus, the performance degradation according to the incident angle may be reduced and the quality of images obtained by the image sensor may be improved.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

**Claims**

1.   An image sensor comprising:

   a sensor substrate including a plurality of unit pixel groups, each of the plurality of unit pixel groups including a first pixel, a second pixel, a third pixel, and a fourth pixel that are arranged in a Bayer pattern in two horizontal directions perpendicular to each other; and
   a color separating lens array spaced apart from the sensor substrate in a vertical direction that is perpendicular to the two horizontal direction, and configured to separate incident light according to wavelengths, and condense the incident light on each of the first to fourth pixels,
   wherein the color separating lens array includes a plurality of pixel corresponding groups respectively corresponding to the plurality of unit pixel groups, each of the plurality of pixel corresponding groups includes first to fourth pixel corresponding regions corresponding to the first to fourth pixels, each of the first to fourth pixel corresponding regions includes a plurality of first nanoposts arranged in a first layer and a plurality of second nanoposts arranged in a second layer, and the second layer is stacked on the first layer in the vertical direction,
   the plurality of pixel corresponding groups include a central group located at a center of the color separating lens array and a plurality of peripheral groups located away from the center, and
   displacements of an arrangement center of the first nanoposts and an arrangement center of the second nanoposts included in each of the first to fourth pixel corresponding regions in a direction perpendicular to the vertical direction are first to fourth displacements, and at least two of the first to fourth displacements are different from each other in each of the plurality of peripheral groups.

2.   The image sensor of claim 1, wherein the first to fourth pixels included in each of the plurality of unit pixel groups each include four photosensitive cells arranged in a 2x2 array, and optionally wherein an order of magnitudes of channel differences generated in four photosensitive cells included in each of the first to fourth pixels facing the first to fourth pixel corresponding regions of the plurality of peripheral groups is same in two or more of the first to fourth pixels.

3.   The image sensor of claim 1 or 2, wherein relative positional relationship of the plurality of second nanoposts in each of the first to fourth pixel corresponding regions in the peripheral group is different from relative positional relationship of the plurality of second nanoposts in each of the first to fourth pixel corresponding regions of the central group.

4. The image sensor of any preceding claim, wherein the first and fourth pixels are green pixels, the second pixel is a blue pixel, and the third pixel is a red pixel, and optionally wherein, in each of the plurality of peripheral groups, the first to fourth displacements are each expressed as a vector sum of a common major displacement and first to fourth minor displacements,

with respect to each of the plurality of peripheral groups, when CRA and $\varphi$ denote a chief ray angle CRA and an azimuth $\varphi$ determined according to the relative position on the image sensor, respectively, a and b denote unit vectors in the two horizontal directions, respectively, and CRA_max denotes a maximum value of the CRA, the common major displacement is expressed as $Cnn*(CRA/CRA\_max)*(-a*\cos\varphi - b*\sin\varphi)$, wherein $C_M$ is a real number greater than 0, and further optionally wherein at least two of the first to fourth minor displacements are different from each other.

5. The image sensor of claim 4, wherein the first minor displacement and the fourth minor displacement are same as each other, and
a magnitude of the second minor displacement and a magnitude of the third minor displacement are greater than a magnitude of the first minor displacement.

6. The image sensor of claim 4, wherein the first minor displacement and the fourth minor displacement are 0.

7. The image sensor of claim 4, wherein the second minor displacement is expressed as $C_2*(CRA/CRA\_max)*(-a*\cos\varphi - b*\sin\varphi)$,

the third minor displacement is expressed as $C_3*(CRA/CRA\_max)*(-a*\cos\varphi - b*\sin\varphi)$, and
$C_2$ and $C_3$ are real numbers greater than 0, and optionally wherein $C_2$ and $C_3$ are different from each other.

8. The image sensor of claim 4, wherein the third minor displacement is 0,

the first minor displacement is expressed as $D_1*(CRA/CRA\_max)*b*\sin\varphi$,
the fourth minor displacement is expressed as $D_4*(CRA/CRA\_max)*a*\cos\varphi$,
the second minor displacement is expressed as $D_{3b}*(CRA/CRA\_max)*b*\sin\varphi + D_{3a}*(CRA/CRA\_max)*a*\cos\varphi$, and
$D_1$, $D_4$, $D_{3b}$, and $D_{3a}$ are real numbers greater than 0, and optionally wherein at least two of $D_1$, $D_4$, $D_{3b}$, and $D_{3a}$ are different from each other.

9. The image sensor of any of claims 4 to 8, wherein relative positions of the plurality of second nanoposts in the second pixel corresponding region included in the peripheral group with respect to the second nanoposts in adjacent first pixel corresponding region and the second nanoposts in adjacent fourth pixel corresponding region are, when compared with relative positions of the plurality of second nanoposts in the second pixel corresponding region included in the central group with respect to the second nanoposts in adjacent first pixel corresponding region and the second nanoposts in adjacent fourth pixel corresponding region, different as much as the second minor displacement.

10. The image sensor of any of claims 4 to 9, wherein relative positions of the plurality of second nanoposts in the third pixel corresponding region included in the peripheral group with respect to the second nanoposts in adjacent first pixel corresponding region and the second nanoposts in adjacent fourth pixel corresponding region are, when compared with relative positions of the plurality of second nanoposts in the third pixel corresponding region included in the central group with respect to the second nanoposts in adjacent first pixel corresponding region and the second nanoposts in adjacent fourth pixel corresponding region, different as much as the third minor displacement.

11. The image sensor of any preceding claim, wherein, in each of the plurality of peripheral groups, an arrangement center of first nanoposts included in each of the first to fourth pixel corresponding regions is out of line with centers of the first to fourth pixels facing the first to fourth pixel corresponding regions by a certain interval in a direction perpendicular to the vertical direction, and the certain interval is in proportional to the CRA defined in each of the plurality of peripheral groups.

12. The image sensor of any preceding claim, wherein relative positional relationship of the plurality of first nanoposts in each of the first to fourth pixel corresponding regions in the peripheral group is different from the relative positional relationship of the plurality of first nanoposts in each of the first to fourth pixel corresponding regions of the central group.

13. The image sensor of any preceding claim, further comprising an anti-reflection layer disposed on the color separating lens array.

14. The image sensor of any preceding claim, further comprising a color filter array between the sensor substrate and the color separating lens array.

15. An electronic apparatus comprising:

a lens assembly including one or more lenses and configured to form an optical image of an object;
an image sensor according to any preceding claim configured to convert the optical image formed by the lens assembly into an electrical signal; and
a processor configured to process a signal generated by the image sensor.

# FIG. 1

# FIG. 2A

1100

| G | B | G | B | G | B |
|---|---|---|---|---|---|
| R | G | R | G | R | G |
| G | B | G | B | G | B |
| R | G | R | G | R | G |
| G | B | G | B | G | B |
| R | G | R | G | R | G |

Y

Z X

# FIG. 2B

# FIG. 2C

130

130G

| 131 | 132 | 131 | 132 | 131 | 132 |
|-----|-----|-----|-----|-----|-----|
| 133 | 134 | 133 | 134 | 133 | 134 |
| 131 | 132 | 131 | 132 | 131 | 132 |
| 133 | 134 | 133 | 134 | 133 | 134 |
| 131 | 132 | 131 | 132 | 131 | 132 |
| 133 | 134 | 133 | 134 | 133 | 134 |

Y
Z⊙ →X

# FIG. 3A

# FIG. 3B

# FIG. 4A

# FIG. 4B

# FIG. 5

# FIG. 6

# FIG. 7A

# FIG. 7B

# FIG. 8

# FIG. 9

# FIG. 10

# FIG. 11

# FIG. 12

# FIG. 13

111                                    112

| Ch1 | Ch2 | Ch1 | Ch2 |
|-----|-----|-----|-----|
| Ch3 | Ch4 | Ch3 | Ch4 |
| Ch1 | Ch2 | Ch1 | Ch2 |
| Ch3 | Ch4 | Ch3 | Ch4 |

113                                    114

# FIG. 14

# FIG. 15

# FIG. 16

# FIG. 17

# FIG. 18

# FIG. 19

# FIG. 20

# FIG. 21

# FIG. 22

131    132    131    132    1104

NP2

145

LE2 } 130

NP1

LE1

ds1

125

GF    BF    GF    BF    150

111    112    111    112    110

Z
Y⊗ → X

# FIG. 23

131    132    131    132    1105

NP2

140

LE2 } 130

NP1

LE1

ds3

125

GF    BF    GF    BF    155

111    112    111    112    110

Z
Y⊗ → X

# FIG. 24

ED00

ELECTRONIC APPARATUS ED01

ED30 — MEMORY ED32

**MEMORY** ED32
VOLATILE MEMORY

ED34
NON-VOLATILE MEMORY
INTERNAL MEMORY — ED36
EXTERNAL MEMORY — ED38

ED40
**PROGRAM** ED46
APPLICATION

ED44
MIDDLEWARE

ED42
OPERATING SYSTEM

ED50
INPUT DEVICE

ED55
SOUND OUTPUT DEVICE

ED60
DISPLAY DEVICE

ED89
BATTERY

ED20
PROCESSOR
ED21
MAIN PROCESSOR
ED23
AUXILIARY PROCESSOR

ED90
COMMUNICATION MODULE
WIRELESS COMMUNICATION MODULE — ED92
WIRED COMMUNICATION MODULE — ED94

ED99
NETWORK

ED04
ELECTRONIC APPARATUS

ED88
POWER MANAGEMENT MODULE

ED96
SUBSCRIBER IDENTIFICATION MODULE

ED97
ANTENNA MODULE

ED98

ED70
AUDIO MODULE

ED76
SENSOR MODULE

ED77
INTERFACE

ED78
CONNECTION TERMINAL

ED02
ELECTRONIC APPARATUS

ED08
SERVER

ED79
HAPTIC MODULE

ED80
CAMERA MODULE

# FIG. 25

ED80

| | | |
|---|---|---|
| 1170 | 1120 FLASH | 1160 |
| LENS ASSEMBLY | 1000 IMAGE SENSOR | |
| | 1140 IMAGE STABILIZER | ISP |
| 1180 ACTUATOR | 1130 AF CONTROLLER | |
| | 1150 MEMORY | |

Europäisches
Patentamt

European
Patent Office

Office européen
des brevets

# EUROPEAN SEARCH REPORT

Application Number

EP 24 18 5934

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/326415 A1 (YUN SEOKHO [KR] ET AL) 13 October 2022 (2022-10-13) * paragraphs [0210] - [0228]; figures 24-36, 52 * | 1-4, 11-15 | INV. H01L27/146 |
| A | US 2021/126035 A1 (ROH SOOKYOUNG [KR] ET AL) 29 April 2021 (2021-04-29) * figures 2-14,33-37 * | 1-15 | |

TECHNICAL FIELDS
SEARCHED      (IPC)

H01L

The present search report has been drawn up for all claims

| Place of search | Date of completion of the search | Examiner |
|---|---|---|
| The Hague | 22 October 2024 | Cabrita, Ana |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 24 18 5934

This annex lists the patent family members relating to the patent documents cited in the above-mentioned European search report.
The members are as contained in the European Patent Office EDP file on
The European Patent Office is in no way liable for these particulars which are merely given for the purpose of information.

22-10-2024

| Patent document cited in search report | Publication date | Patent family member(s) | | Publication date |
|---|---|---|---|---|
| US 2022326415 A1 | 13-10-2022 | NONE | | |
| US 2021126035 A1 | 29-04-2021 | CN | 112701133 A | 23-04-2021 |
| | | EP | 3812801 A1 | 28-04-2021 |
| | | EP | 4398304 A2 | 10-07-2024 |
| | | JP | 2021069119 A | 30-04-2021 |
| | | US | 2021126035 A1 | 29-04-2021 |
| | | US | 2024204022 A1 | 20-06-2024 |

EPO FORM P0459

For more details about this annex : see Official Journal of the European Patent Office, No. 12/82